# EUROPEAN PATENT APPLICATION

(11) **EP 4 749 407 A1**
(43) Date of publication of application: **27.05.2026**
(21) Application number: 25773013.5
(22) Date of filing: 17.03.2025
(51) Int. Cl.: G06F 3/01

(54) **KEY OPERATION METHOD AND RELATED APPARATUS**

(30) Priority: 20.03.2024 CN 202410325144
(71) Applicant: HUAWEI TECHNOLOGIES CO., LTD., Shenzhen 518129 (CN)
(72) Inventor: ZHANG, Ze, Shenzhen, Guangdong 518129 (CN); JIN, Junye, Shenzhen, Guangdong 518129 (CN); CAI, Licheng, Shenzhen, Guangdong 518129 (CN); DONG, Hanyong, Shenzhen, Guangdong 518129 (CN); ZOU, Lin, Shenzhen, Guangdong 518129 (CN); REN, Jingxuan, Shenzhen, Guangdong 518129 (CN)
(74) Representative: Grünecker Patent- und Rechtsanwälte PartG mbB
(86) International application number: PCT/CN2025/082853
(87) International publication number: WO 2025/195314

(57) **Abstract**

This application provides a button operation method and a related apparatus. A pressure sensor, an optical sensor, a bioelectric sensor, and a temperature sensor may be disposed in a first button of an electronic device. The electronic device may accurately identify, based on data detected by a sensor in the first button, whether a touch operation is performed on the first button, and a type of the touch operation. In this way, the first button may support a plurality of types of touch operations (for example, a tap operation, a touch and hold operation, a light tap operation, a heavy tap operation, and a swipe-up operation). According to the foregoing method, a user performs different types of touch operations on the first button, to control the electronic device to implement a plurality of functions.

## Description

This application claims priority to Chinese Patent Application No. 202410325144.8, filed with the China National Intellectual Property Administration on March 20, 2024, and entitled "BUTTON OPERATION METHOD AND RELATED APPARATUS", which is incorporated herein by reference in its entirety.

### TECHNICAL FIELD

This application relates to the field of terminal technologies, and in particular, to a button operation method and a related apparatus.

### BACKGROUND

Currently, many electronic devices are equipped with buttons. For example, a button on a mobile phone may include a physical button like a power button, a volume up button, or a volume down button. A button on a smartwatch may include a physical button like a side button. In addition to a physical button, a button on an electronic device further include a virtual button on a screen. A user can control the electronic device through the foregoing buttons. How to improve button performance and enhance user interaction experience is an urgent problem to be resolved.

### SUMMARY

This application provides a button operation method and a related apparatus. A plurality of types of sensors may be disposed in a button of an electronic device, for example, a pressure sensor, an optical sensor, a bioelectric sensor, and a temperature sensor. Based on the foregoing plurality of types of sensors, the electronic device may more accurately identify a plurality of types of touch operations performed on the button. The button may support various user interaction modes. A user may perform different types of touch operations on the button to control the electronic device to implement a plurality of functions. In addition, the button supports underwater interaction. Through the foregoing button, the user can conveniently use the electronic device underwater and on water. This can enhance user interaction experience of the button.

According to a first aspect, this application provides a button operation method. The method may be applied to an electronic device including a first button. The electronic device may obtain a plurality of pieces of data of a plurality of sensors, where the plurality of sensors are disposed in the first button, and the plurality of sensors include at least two of a pressure sensor, a bioelectric sensor, an optical sensor, and a temperature sensor. The electronic device may determine, based on the plurality of pieces of data, a first touch operation performed on the first button.

In some embodiments, determining, based on the plurality of pieces of data, the first touch operation performed on the first button may include: determining, based on the plurality of pieces of data, whether the first touch operation is performed on the first button, and when the first touch operation is performed on the first button, identifying a type of the first touch operation.

The foregoing method can reduce cases of incorrectly determining a button-press behavior of a user through only a single type of sensor, and improve accuracy of touch operation detection. In addition, data of the plurality of sensors may be used to determine a plurality of states of the first button, for example, a state in which a light tap operation is performed, a state in which a heavy tap operation is performed, a state in which a tap operation is performed, a state in which a heavy tap operation is performed, and a state in which a swipe operation like a swipe-up operation is performed. Therefore, based on the foregoing plurality of sensors, the first button may support various user interaction modes. A user may perform different types of touch operations on the first button to control the electronic device to implement a plurality of functions. This can improve user experience of using the electronic device.

In some embodiments, the first button may be a physical button, or may be a virtual button. A plurality of types of sensors disposed in the virtual button may indicate that the plurality of sensors are disposed below a screen of the electronic device. When the first button is the virtual button, the first touch operation may be a touch operation performed on the screen of the electronic device. Because one or more sensors (such as the pressure sensor, the bioelectric sensor, the optical sensor, and the temperature sensor) disposed in the first button are not easily affected by a water medium, the electronic device may be used underwater. The user can conveniently use the electronic device underwater and on water. This can improve user experience of using the electronic device.

With reference to the first aspect, in some embodiments, if the plurality of pieces of data of the plurality of sensors in the first button meet at least two of the following conditions, the electronic device may determine that the first touch operation is performed on the first button:
the plurality of sensors include the pressure sensor, the plurality of pieces of data include pressure data of the pressure sensor, and the pressure data of the pressure sensor is greater than a first pressure threshold;
the plurality of sensors include the optical sensor, the plurality of pieces of data include a photoelectric current signal of the optical sensor, and a signal strength of the photoelectric current signal of the optical sensor is greater than a first signal strength threshold;
the plurality of sensors include the bioelectric sensor, the plurality of pieces of data include a bioelectric signal of the bioelectric sensor, and the bioelectric signal of the bioelectric sensor indicates that the bioelectric sensor is connected to another bioelectric sensor disposed on the electronic device; and
the plurality of sensors include the temperature sensor, the plurality of pieces of data include temperature data of the temperature sensor, and a variation of the temperature data of the temperature sensor is greater than a temperature variation threshold.

It can be learned that the electronic device may detect, in combination with at least two types of sensors in the first button, whether a touch operation is performed on the first button. This can reduce cases of incorrectly determining a button-press behavior of the user through only a single type of sensor. The foregoing method can reduce cases in which a mistouch on the button is identified as a touch operation of the user, and more accurately identify a touch operation performed on the button.

With reference to the first aspect, in some embodiments, the plurality of sensors include the optical sensor, and after determining that the first touch operation is performed on the first button, the electronic device may determine, based on the photoelectric current signal, that the type of the first touch operation is a press operation or a swipe operation.

The optical sensor may include a plurality of optical receivers.

If there is a change trend that strengths of photoelectric current signals of the plurality of optical receivers in the first button simultaneously increase and then simultaneously decrease, the electronic device may determine that the touch operation on the first button is the press operation.

If there is a change trend that when a strength of a photoelectric current signal of one optical receiver in the plurality of optical receivers of the first button decreases, a strength of a photoelectric current signal of another optical receiver increases, the electronic device may determine that the touch operation on the first button is the swipe operation.

It can be learned that the electronic device may identify, by using the optical sensor in the first button, the press operation and the swipe operation that are performed on the first button, and further execute a task corresponding to a corresponding touch operation. According to the foregoing embodiments, user interaction experience of the electronic device can be improved.

With reference to the first aspect, in some embodiments, the optical sensor includes the plurality of optical receivers; and the electronic device may determine a swipe direction of the first touch operation based on positions of the plurality of optical receivers and moments at which the plurality of optical receivers detect photoelectric current signals whose signal strength is greater than a second signal strength threshold. The second signal strength threshold may be the same as or different from the first signal strength threshold.

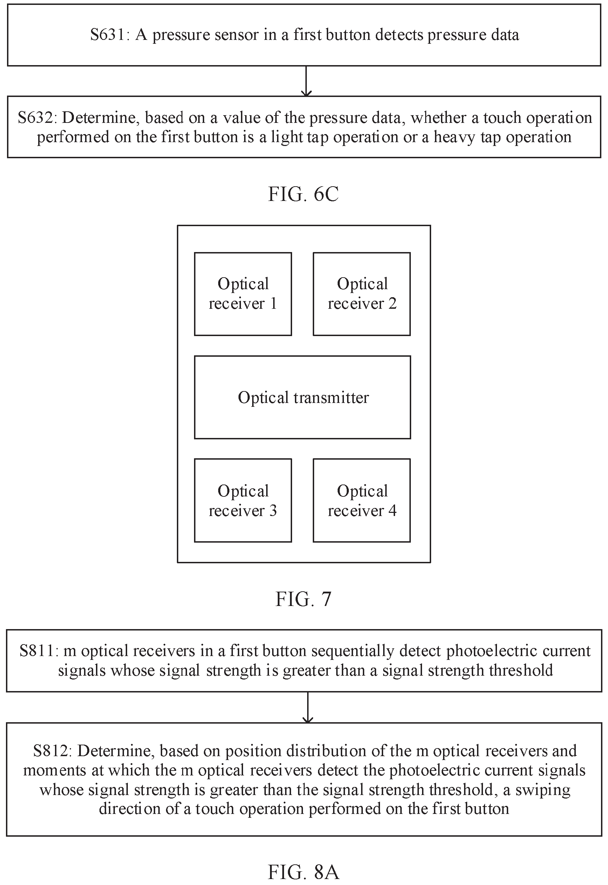

For the positions of the plurality of optical receivers, refer to a diagram of position distribution shown in FIG. 7 in this application. The swipe direction of the first touch operation may include swiping to the left, swiping to the right, swiping upward, swiping downward, swiping diagonally down to the left, swiping diagonally up to the left, swiping diagonally down to the right, swiping diagonally up to the right, and the like.

With reference to the first aspect, in some embodiments, the electronic device may determine pressing duration of the first touch operation based on the photoelectric current signal; or the electronic device may determine a press force of the first touch operation based on the photoelectric current signal.

The electronic device may determine the type of the first touch operation based on the pressing duration. The type of the first touch operation may include pressing operations with different pressing duration, for example, a tap operation and a touch and hold operation.

The electronic device may determine the type of the first touch operation based on the press force. The type of the first touch operation may include press operations with different press forces, for example, a light tap operation and a heavy tap operation.

With reference to the first aspect, in some embodiments, the optical sensor in the first button detects, twice within a preset time period, a photoelectric current signal whose signal strength is greater than the second signal strength threshold, and the electronic device may determine that the first touch operation includes two press operations, and determine pressing duration of the two press operations based on the photoelectric current signal. The electronic device may determine the type of the first touch operation based on the pressing duration of the two press operations, for example, two consecutive tap operations, or a tap operation and a touch and hold operation that are consecutive.

It can be learned that the electronic device may identify, by using the optical sensor in the first button, a plurality of types of touch operations performed on the first button. In this way, the first button may support various user interaction modes. The user may perform a plurality of touch operations on the first button to use corresponding functions.

With reference to the first aspect, in some embodiments, the plurality of sensors include the pressure sensor, and after determining that the first touch operation is performed on the first button, the electronic device may determine, based on the pressure data, that the type of the first touch operation is a press operation or a swipe operation.

A plurality of pressure sensors may be disposed in the first button.

If there is a change trend that pressure data of a plurality of pressure sensors in the first button simultaneously increases and then simultaneously decreases, the electronic device may determine that the touch operation on the first button is the press operation.

If there is a change trend that when pressure data of one pressure sensor in the plurality of pressure sensors of the first button decreases, pressure data of another pressure sensor increases, the electronic device may determine that the touch operation on the first button is the swipe operation.

It can be learned that the electronic device may identify, by using the pressure sensor in the first button, the press operation and the swipe operation that are performed on the first button, and further execute a task corresponding to a corresponding touch operation. According to the foregoing embodiments, user interaction experience of the electronic device can be improved.

With reference to the first aspect, in some embodiments, the pressure sensor includes a plurality of pressure sensors; and the electronic device may determine a swipe direction of the first touch operation based on positions of the plurality of pressure sensors and moments at which the plurality of pressure sensors detect pressure data greater than a second pressure threshold. The second pressure threshold and the first pressure threshold may be the same or different.

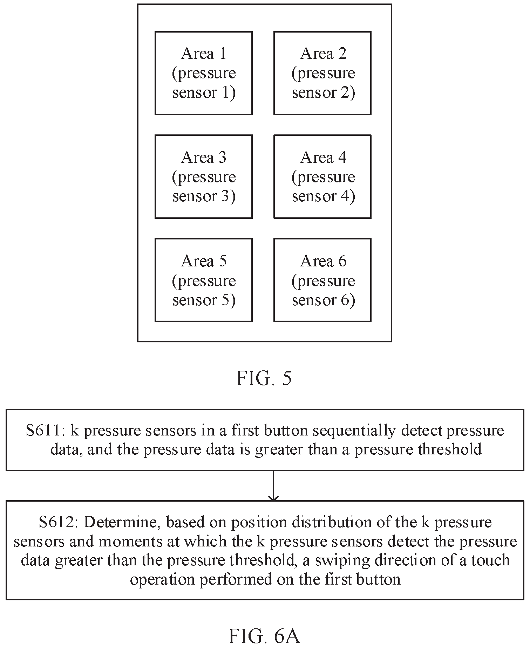

For the positions of the plurality of pressure sensors, refer to a diagram of position distribution shown in FIG. 5 in this application.

With reference to the first aspect, in some embodiments, the electronic device may determine pressing duration of the first touch operation based on the pressure data; or the electronic device may determine a press force of the first touch operation based on the pressure data.

With reference to the first aspect, in some embodiments, the pressure sensor in the first button detects, twice within a preset time period, pressure data greater than the second pressure threshold, and the electronic device may determine that the first touch operation includes two press operations, and determine pressing duration of the two press operations based on the pressure data. The electronic device may determine the type of the first touch operation based on the pressing duration of the two press operations, for example, two consecutive tap operations, or a tap operation and a touch and hold operation that are consecutive.

It can be learned that the electronic device may identify, by using the pressure sensor in the first button, a plurality of types of touch operations performed on the first button. In this way, the first button may support various user interaction modes. The user may perform a plurality of touch operations on the first button to use corresponding functions.

With reference to the first aspect, in some embodiments, the plurality of sensors include the optical sensor and the pressure sensor. The electronic device may receive a first blood pressure monitoring operation, where the first blood pressure monitoring operation is used to start blood pressure monitoring. The electronic device may detect, by using the pressure sensor, a first position at which the first button is pressed through a second touch operation. If the first position is not in a position corresponding to the optical sensor, the electronic device may output a first prompt, where the first prompt is used to prompt the user to adjust a position of pressing the first button.

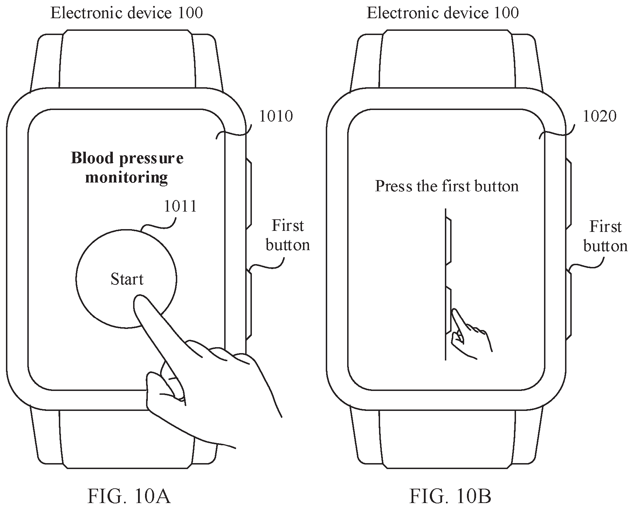

For the first blood pressure monitoring operation, refer to a user operation on a start control 1011 shown in FIG. 10A in this application.

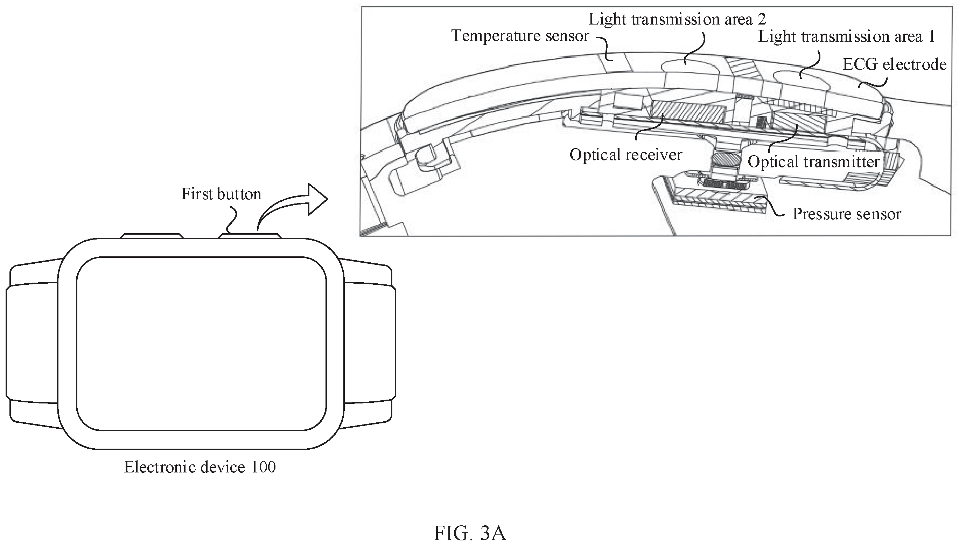

The position corresponding to the optical sensor may be a position corresponding to the optical sensor on a touch surface of the first button. For the position corresponding to the optical sensor, refer to a position of a light transmission area 1 and a position of a light transmission area 2 shown in FIG. 3A in this application.

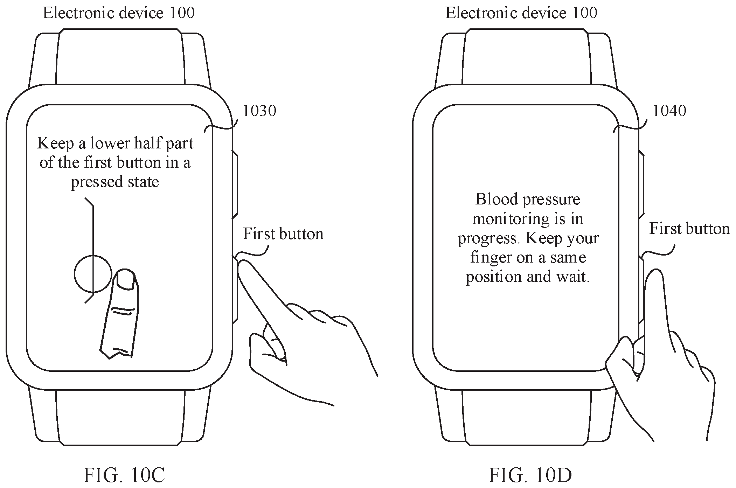

For the first prompt, refer to prompt information in a user interface 1030 shown in FIG. 10C in this application.

It can be learned that, during the blood pressure monitoring, the electronic device may detect, by using the pressure sensor in the first button, whether the position pressed by the user on the first button is appropriate. If the position pressed by the user on the first button is inappropriate, the electronic device may prompt the user to adjust the position of pressing the first button. This can improve accuracy of the blood pressure monitoring.

With reference to the first aspect, in some embodiments, the plurality of sensors further include the bioelectric sensor. If the first position is in the position corresponding to the optical sensor, the electronic device may determine whether signal quality of a PPG signal detected by the optical sensor meets a first quality indicator; and if the signal quality of the PPG signal meets the first quality indicator, the electronic device may determine blood pressure of the user based on the PPG signal and the bioelectric signal of the bioelectric sensor; or if the signal quality of the PPG signal does not meet the first quality indicator, the electronic device may output a second prompt, where the second prompt is used to prompt the user to keep stable when pressing the first button.

It can be learned that, during the blood pressure monitoring, the electronic device may further determine whether the signal quality of the PPG signal detected by the optical sensor in the first button meets the first quality indicator. The position pressed by a finger of the user on the first button is appropriate, but the signal quality of the PPG signal does not meet the quality indicator, indicating that, when the first button is pressed, pressing is unstable, for example, the finger of the user may shake. Therefore, when the signal quality of the PPG signal does not meet the first quality indicator, the electronic device may prompt the user to keep stable when pressing the first button. This can improve accuracy of the blood pressure monitoring.

With reference to the first aspect, in some embodiments, the plurality of sensors include the pressure sensor. The electronic device may further display a first interface, where the first interface is used to prompt the user to press the first button, and control a press force to be a first force within first duration. The electronic device may further determine a press force and pressing duration of a third touch operation in response to detecting the third touch operation performed on the first button. The electronic device may further output a disease risk prompt based on the press force and the pressing duration.

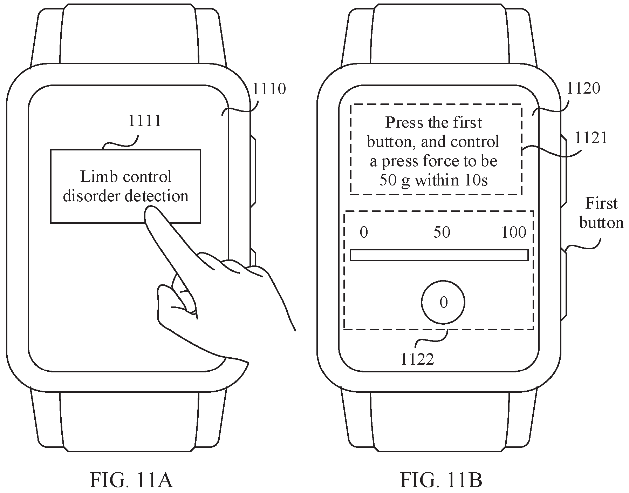

For the first interface, refer to a user interface 1120 shown in FIG. 11B of this application.

If the press force is less than the first force, or a fluctuation of the press force is greater than a force fluctuation threshold, the electronic device may output the disease risk prompt. When the press force is less than the first force, the disease risk prompt output by the electronic device may include: giving the user a prompt that there is a risk of peripheral nerve injury. When the fluctuation of the press force is greater than the force fluctuation threshold, the disease risk prompt output by the electronic device may include: giving the user a prompt that there is a risk of Parkinson's disease or alcohol paralysis.

It can be learned that the electronic device may simply and quickly detect, by using the pressure sensor in the first button, whether the user has a limb control disorder. When determining that the user has the limb control disorder, the electronic device may output the disease risk prompt. The foregoing embodiments can help the user conveniently perform limb control disorder detection anytime and anywhere, to help the user better pay attention to physical health.

With reference to the first aspect, in some embodiments, the first button does not include a touch sensor. The touch sensor may be a capacitive touch sensor or the like that is activated by touch. When the first button is the virtual button, that the first button does not include the touch sensor may indicate that no touch sensor needs to be disposed below the screen of the electronic device. The electronic device may detect, by using one or more sensors of the pressure sensor, the optical sensor, the bioelectric sensor, and the temperature sensor that are disposed below the screen, a touch operation performed on the screen. In comparison with the touch sensor, the pressure sensor, the optical sensor, the bioelectric sensor, and the temperature sensor are not easily affected by a water medium. Therefore, disposing one or more of the pressure sensor, the optical sensor, the bioelectric sensor, and the temperature sensor below the screen may enable the screen to support interaction with the user underwater. In this way, the user can conveniently use the electronic device underwater and on water. This can improve user experience of using the electronic device.

According to a second aspect, this application provides a button operation method. The method may be applied to an electronic device including a first button and an optical sensor, where the optical sensor is disposed in the first button. The electronic device may obtain a photoelectric current signal of the optical sensor. The electronic device may determine, based on the photoelectric current signal, a first touch operation performed on the first button.

It can be learned that the photoelectric current signal may be used to determine a plurality of states of the first button, for example, a state in which a light tap operation is performed, a state in which a heavy tap operation is performed, a state in which a tap operation is performed, a state in which a heavy tap operation is performed, and a state in which a swipe operation like a swipe-up operation is performed. Therefore, based on the optical sensor, the first button may support various user interaction modes. A user may perform different types of touch operations on the first button to control the electronic device to implement a plurality of functions. This can improve user experience of using the electronic device.

With reference to the second aspect, in some embodiments, if a signal strength of the photoelectric current signal is greater than a first signal strength threshold, the electronic device may determine that the first touch operation is performed on the first button.

With reference to the second aspect, in some embodiments, after determining that the first touch operation is performed on the first button, the electronic device may determine, based on the photoelectric current signal, that a type of the first touch operation is a press operation or a swipe operation.

The optical sensor may include a plurality of optical receivers.

If there is a change trend that strengths of photoelectric current signals of the plurality of optical receivers in the first button simultaneously increase and then simultaneously decrease, the electronic device may determine that the touch operation on the first button is the press operation.

If there is a change trend that when a strength of a photoelectric current signal of one optical receiver in the plurality of optical receivers of the first button decreases, a strength of a photoelectric current signal of another optical receiver increases, the electronic device may determine that the touch operation on the first button is the swipe operation.

It can be learned that the electronic device may identify, by using the optical sensor in the first button, the press operation and the swipe operation that are performed on the first button, and further execute a task corresponding to a corresponding touch operation. According to the foregoing embodiments, user interaction experience of the electronic device can be improved.

With reference to the second aspect, in some embodiments, the optical sensor includes the plurality of optical receivers; and the electronic device may determine a swipe direction of the first touch operation based on positions of the plurality of optical receivers and moments at which the plurality of optical receivers detect photoelectric current signals whose signal strength is greater than a second signal strength threshold.

The swipe direction of the first touch operation may include swiping to the left, swiping to the right, swiping upward, swiping downward, swiping diagonally down to the left, swiping diagonally up to the left, swiping diagonally down to the right, swiping diagonally up to the right, and the like.

With reference to the second aspect, in some embodiments, the electronic device may determine pressing duration of the first touch operation based on the photoelectric current signal; or the electronic device may determine a press force of the first touch operation based on the photoelectric current signal.

The electronic device may determine the type of the first touch operation based on the pressing duration. The type of the first touch operation may include pressing operations with different pressing duration, for example, a tap operation and a touch and hold operation.

The electronic device may determine the type of the first touch operation based on the press force. The type of the first touch operation may include press operations with different press forces, for example, a light tap operation and a heavy tap operation.

With reference to the second aspect, in some embodiments, the optical sensor in the first button detects, twice within a preset time period, a photoelectric current signal whose signal strength is greater than the second signal strength threshold, and the electronic device may determine that the first touch operation includes two press operations, and determine pressing duration of the two press operations based on the photoelectric current signal. The electronic device may determine the type of the first touch operation based on the pressing duration of the two press operations, for example, two consecutive tap operations, or a tap operation and a touch and hold operation that are consecutive.

It can be learned that the electronic device may identify, by using the optical sensor in the first button, a plurality of types of touch operations performed on the first button. In this way, the first button may support various user interaction modes. The user may perform a plurality of touch operations on the first button to use corresponding functions.

With reference to the second aspect, in some embodiments, the first button does not include a touch sensor.

According to a third aspect, this application provides a button operation method. The method may be applied to an electronic device including a first button, an optical sensor, and a pressure sensor. The optical sensor and the pressure sensor are disposed in the first button. The electronic device may receive a first blood pressure monitoring operation, where the first blood pressure monitoring operation is used to start blood pressure monitoring. The electronic device may detect, by using the pressure sensor, a first position at which the first button is pressed through a first touch operation. If the first position is not in a position corresponding to the optical sensor, the electronic device may output a first prompt, where the first prompt is used to prompt a user to adjust a position of pressing the first button.

For the first blood pressure monitoring operation, refer to a user operation on a start control 1011 shown in FIG. 10A in this application.

The position corresponding to the optical sensor may be a position corresponding to the optical sensor on a touch surface of the first button. For the position corresponding to the optical sensor, refer to a position of a light transmission area 1 and a position of a light transmission area 2 shown in FIG. 3A in this application.

For the first prompt, refer to prompt information in a user interface 1030 shown in FIG. 10C in this application.

It can be learned that, during the blood pressure monitoring, the electronic device may detect, by using the pressure sensor in the first button, whether the position pressed by the user on the first button is appropriate. If the position pressed by the user on the first button is inappropriate, the electronic device may prompt the user to adjust the position of pressing the first button. This can improve accuracy of the blood pressure monitoring.

With reference to the third aspect, in some embodiments, a bioelectric sensor is further disposed in the first button. If the first position is in the position corresponding to the optical sensor, the electronic device may determine whether signal quality of a PPG signal detected by the optical sensor meets a first quality indicator; and if the signal quality of the PPG signal meets the first quality indicator, the electronic device may determine blood pressure of the user based on the PPG signal and the bioelectric signal of the bioelectric sensor; or if the signal quality of the PPG signal does not meet the first quality indicator, the electronic device may output a second prompt, where the second prompt is used to prompt the user to keep stable when pressing the first button.

It can be learned that, during the blood pressure monitoring, the electronic device may further determine whether the signal quality of the PPG signal detected by the optical sensor in the first button meets the first quality indicator. The position pressed by a finger of the user on the first button is appropriate, but the signal quality of the PPG signal does not meet the quality indicator, indicating that, when the first button is pressed, pressing is unstable, for example, the finger of the user may shake. Therefore, when the signal quality of the PPG signal does not meet the first quality indicator, the electronic device may prompt the user to keep stable when pressing the first button. This can improve accuracy of the blood pressure monitoring.

With reference to the third aspect, in some embodiments, the electronic device may obtain a plurality of pieces of data of a plurality of sensors, where the plurality of sensors are disposed in the first button, and the plurality of sensors include at least two of the pressure sensor, the bioelectric sensor, the optical sensor, and a temperature sensor. When no blood pressure monitoring is performed, the electronic device may determine, based on the plurality of pieces of data, the first touch operation performed on the first button.

In some embodiments, determining, based on the plurality of pieces of data, the first touch operation performed on the first button may include: determining, based on the plurality of pieces of data, whether the first touch operation is performed on the first button, and when the first touch operation is performed on the first button, identifying a type of the first touch operation.

It can be learned that, in addition to being used to perform blood pressure monitoring, the first button may be used to receive a plurality of types of touch operations. The foregoing method can reduce cases of incorrectly determining a button-press behavior of the user through only a single type of sensor, and improve accuracy of touch operation detection. In addition, data of the plurality of sensors may be used to determine a plurality of states of the first button, for example, a state in which a light tap operation is performed, a state in which a heavy tap operation is performed, a state in which a tap operation is performed, a state in which a heavy tap operation is performed, and a state in which a swipe operation like a swipe-up operation is performed. Therefore, based on the foregoing plurality of sensors, the first button may support various user interaction modes. The user may perform different types of touch operations on the first button to control the electronic device to implement a plurality of functions. This can improve user experience of using the electronic device.

With reference to the third aspect, in some embodiments, if the plurality of pieces of data of the plurality of sensors in the first button meet at least two of the following conditions, the electronic device may determine that the first touch operation is performed on the first button:
the plurality of sensors include the pressure sensor, the plurality of pieces of data include pressure data of the pressure sensor, and the pressure data of the pressure sensor is greater than a first pressure threshold;
the plurality of sensors include the optical sensor, the plurality of pieces of data include a photoelectric current signal of the optical sensor, and a signal strength of the photoelectric current signal of the optical sensor is greater than a first signal strength threshold;
the plurality of sensors include the bioelectric sensor, the plurality of pieces of data include a bioelectric signal of the bioelectric sensor, and the bioelectric signal of the bioelectric sensor indicates that the bioelectric sensor is connected to another bioelectric sensor disposed on the electronic device; and
the plurality of sensors include the temperature sensor, the plurality of pieces of data include temperature data of the temperature sensor, and a variation of the temperature data of the temperature sensor is greater than a temperature variation threshold.

It can be learned that the electronic device may detect, in combination with at least two types of sensors in the first button, whether a touch operation is performed on the first button. This can reduce cases of incorrectly determining a button-press behavior of the user through only a single type of sensor. The foregoing method can reduce cases in which a mistouch on the button is identified as a touch operation of the user, and more accurately identify a touch operation performed on the button.

With reference to the third aspect, in some embodiments, the plurality of sensors include the optical sensor, and after determining that the first touch operation is performed on the first button, the electronic device may determine, based on the photoelectric current signal, that the type of the first touch operation is a press operation or a swipe operation.

With reference to the third aspect, in some embodiments, the optical sensor includes the plurality of optical receivers; and the electronic device may determine a swipe direction of the first touch operation based on positions of the plurality of optical receivers and moments at which the plurality of optical receivers detect photoelectric current signals whose signal strength is greater than a second signal strength threshold. The second signal strength threshold may be the same as or different from the first signal strength threshold.

With reference to the third aspect, in some embodiments, the electronic device may determine pressing duration of the first touch operation based on the photoelectric current signal; or the electronic device may determine a press force of the first touch operation based on the photoelectric current signal.

The electronic device may determine the type of the first touch operation based on the pressing duration. The type of the first touch operation may include pressing operations with different pressing duration, for example, a tap operation and a touch and hold operation.

The electronic device may determine the type of the first touch operation based on the press force. The type of the first touch operation may include press operations with different press forces, for example, a light tap operation and a heavy tap operation.

It can be learned that the electronic device may identify, by using the optical sensor in the first button, a plurality of types of touch operations performed on the first button. In this way, the first button may support various user interaction modes. The user may perform a plurality of touch operations on the first button to use corresponding functions.

With reference to the third aspect, in some embodiments, the plurality of sensors include the pressure sensor, and after determining that the first touch operation is performed on the first button, the electronic device may determine, based on the pressure data, that the type of the first touch operation is a press operation or a swipe operation.

With reference to the third aspect, in some embodiments, the pressure sensor includes a plurality of pressure sensors; and the electronic device may determine a swipe direction of the first touch operation based on positions of the plurality of pressure sensors and moments at which the plurality of pressure sensors detect pressure data greater than a second pressure threshold. The second pressure threshold and the first pressure threshold may be the same or different.

For the positions of the plurality of pressure sensors, refer to a diagram of position distribution shown in FIG. 5 in this application.

With reference to the third aspect, in some embodiments, the electronic device may determine pressing duration of the first touch operation based on the pressure data; or the electronic device may determine a press force of the first touch operation based on the pressure data.

It can be learned that the electronic device may identify, by using the pressure sensor in the first button, a plurality of types of touch operations performed on the first button. In this way, the first button may support various user interaction modes. The user may perform a plurality of touch operations on the first button to use corresponding functions.

According to a fourth aspect, this application provides a button operation method. The method may be applied to an electronic device including a first button and a pressure sensor, where the pressure sensor is disposed in the first button. The electronic device may display a first interface, where the first interface is used to prompt a user to press the first button, and control a press force to be a first force within first duration. The electronic device may determine a press force and pressing duration of a touch operation in response to detecting the touch operation performed on the first button. The electronic device may output a disease risk prompt based on the press force and the pressing duration.

For the first interface, refer to a user interface 1120 shown in FIG. 11B of this application.

If the press force is less than the first force, or a fluctuation of the press force is greater than a force fluctuation threshold, the electronic device may output the disease risk prompt. When the press force is less than the first force, the disease risk prompt output by the electronic device may include: giving the user a prompt that there is a risk of peripheral nerve injury. When the fluctuation of the press force is greater than the force fluctuation threshold, the disease risk prompt output by the electronic device may include: giving the user a prompt that there is a risk of Parkinson's disease or alcohol paralysis.

It can be learned that the electronic device may simply and quickly detect, by using the pressure sensor in the first button, whether the user has a limb control disorder. When determining that the user has the limb control disorder, the electronic device may output the disease risk prompt. The foregoing embodiments can help the user conveniently perform limb control disorder detection anytime and anywhere, to help the user better pay attention to physical health.

According to a fifth aspect, this application provides an electronic device. The electronic device may include a first button, a memory, and a processor. At least two of a pressure sensor, a bioelectric sensor, an optical sensor, and a temperature sensor are disposed in the first button. The memory may be configured to store a computer program. The processor may be configured to invoke the computer program, so that the electronic device performs the method according to any one of the possible implementations of the first aspect, the second aspect, the third aspect, or the fourth aspect.

According to a sixth aspect, this application provides a button, where one or more of the following sensors are disposed in the button: a pressure sensor, an optical sensor, a bioelectric sensor, and a temperature sensor. The pressure sensor is configured to detect pressure data. The optical sensor is configured to detect a photoelectric current signal. The bioelectric sensor is configured to detect a bioelectric signal. The temperature sensor is configured to detect temperature data.

In some embodiments, the first button does not include a touch sensor.

According to a seventh aspect, this application provides a computer-readable storage medium, including instructions. When the instructions are run on an electronic device, the electronic device is enabled to perform the method according to any one of the possible implementations of the first aspect, the second aspect, the third aspect, or the fourth aspect.

According to an eighth aspect, this application provides a computer program product. The computer program product may include computer instructions. When the computer instructions are run on an electronic device, the electronic device is enabled to perform the method according to any one of the possible implementations of the first aspect, the second aspect, the third aspect, or the fourth aspect.

According to a ninth aspect, this application provides a chip. The chip is used in an electronic device, the chip includes one or more processors, and the processor is configured to invoke computer instructions to enable the electronic device to perform the method according to any one of the possible implementations of the first aspect, the second aspect, the third aspect, or the fourth aspect.

It may be understood that the electronic device provided in the fifth aspect, the computer-readable storage medium provided in the seventh aspect, the computer program product provided in the eighth aspect, and the chip provided in the ninth aspect are all configured to perform the method provided in embodiments of this application. Therefore, for beneficial effect that can be achieved, refer to beneficial effect in the corresponding method. Details are not described herein again.

### BRIEF DESCRIPTION OF DRAWINGS

FIG. 1 is a diagram of a structure of an electronic device 100 according to an embodiment of this application;
FIG. 2 is a diagram of a structure of another electronic device 100 according to an embodiment of this application;
FIG. 3A and FIG. 3B are diagrams of a button according to an embodiment of this application;
FIG. 3C is a diagram of a pressure sensor disposed in a first button under an external force according to an embodiment of this application;
FIG. 3D is a diagram of detecting a photoelectric current signal by an optical sensor in a first button according to an embodiment of this application;
FIG. 4 is a button mistouch detection method according to an embodiment of this application;
FIG. 5 is a diagram of position distribution of pressure sensors in a first button according to an embodiment of this application;
FIG. 6A to FIG. 6C show some methods for detecting a type of a touch operation based on pressure data according to an embodiment of this application;
FIG. 7 is a diagram of position distribution of an optical transmitter and optical receivers that are included in an optical sensor of a first button according to an embodiment of this application;
FIG. 8A and FIG. 8B show methods for detecting a type of a touch operation based on a photoelectric current signal according to an embodiment of this application;
FIG. 9 shows a method for performing blood pressure monitoring through a first button according to an embodiment of this application;
FIG. 10A to FIG. 10D are diagrams of some blood pressure monitoring scenarios according to an embodiment of this application; and
FIG. 11A to FIG. 11D are diagrams of some limb disorder risk detection scenarios according to an embodiment of this application.

### DESCRIPTION OF EMBODIMENTS

The following describes the technical solutions in embodiments of this application with reference to the accompanying drawings in embodiments of this application. In the descriptions of embodiments of this application, terms used in the following embodiments are merely intended to describe purposes of specific embodiments, but are not intended to limit this application. The terms "one", "the", "the foregoing", "this", and "the one" of singular forms used in this specification and the appended claims of this application are also intended to include expressions such as "one or more", unless otherwise specified in the context clearly. It should be further understood that in the following embodiments of this application, "at least one" and "one or more" mean one, two, or more. The term "and/or" is used to describe an association relationship between associated objects and represents that three relationships may exist. For example, A and/or B may represent the following cases: Only A exists, both A and B exist, and only B exists, where A and B each may be singular or plural. The character "/" generally indicates an "or" relationship between associated objects.

Reference to "an embodiment", "some embodiments", or the like described in this specification indicates that one or more embodiments of this application include a specific feature, structure, or characteristic described with reference to embodiments. Therefore, statements such as "in an embodiment", "in some embodiments", "in some other embodiments", and "in other embodiments" that appear at different places in this specification do not necessarily mean referring to a same embodiment. Instead, the statements mean "one or more but not all of embodiments", unless otherwise specifically emphasized in another manner. Terms "include", "contain", "have", and variants of the terms all mean "include but are not limited to", unless otherwise specifically emphasized in another manner. The term "connection" includes a direct connection and an indirect connection, unless otherwise indicated. "First" and "second" are merely intended for a purpose of description, and shall not be understood as an indication or implication of relative importance or implicit indication of a quantity of indicated technical features.

In embodiments of this application, the word "example", "for example", or the like is used to represent giving an example, an illustration, or a description. Any embodiment or design scheme described as "example" or "for example" in embodiments of this application should not be explained as being more preferred or having more advantages than another embodiment or design scheme. Exactly, use of the word "example", "for example", or the like is intended to present a relative concept in a specific manner.

This application provides a button operation method, which may be applied to an electronic device including a first button. The first button may be a physical button, and a plurality of sensors may be disposed in the first button. The plurality of sensors may include at least two of a pressure sensor, a bioelectric sensor, an optical sensor, and a temperature sensor. The electronic device may obtain a plurality of pieces of data of the plurality of sensors in the first button, and determine, based on the plurality of pieces of data, whether a first touch operation is performed on the first button and a type of the first touch operation.

The pressure sensor may be configured to detect pressure data. The bioelectric sensor may be configured to detect a bioelectric signal of a human body. For example, the bioelectric sensor may be an electrocardiogram (electrocardiogram, ECG) sensor. The optical sensor may be configured to detect a photoelectric current signal. The optical sensor may include an optical transmitter and an optical receiver. The optical transmitter may be configured to transmit an optical signal. The optical receiver may be configured to receive an optical signal. The optical sensor may generate a photoelectric current signal based on the optical signal received by the optical receiver. For example, the optical sensor may be a photoplethysmography (photoplethysmography, PPG) sensor. The temperature sensor may be configured to detect temperature data.

It can be learned from the foregoing method that the electronic device may detect, in combination with the data of the plurality of sensors in the first button, whether there is a touch operation on the first button. This can improve accuracy of touch operation detection, and reduce cases in which a mistouch on the first button is identified as a touch operation of a user.

When the first touch operation is performed on the first button, the electronic device may determine the type of the first touch operation based on the data of the sensors in the first button. For example, the type of the first touch operation may be a press operation or a swipe operation. The type of the first touch operation is not limited in this application. For example, the electronic device may determine pressing duration of the first touch operation based on the data of the sensors in the first button, to further determine that the first touch operation is a tap operation or a touch and hold operation. Alternatively, the electronic device may determine a press force of the first touch operation based on the data of the sensors in the first button, to further determine that the first touch operation is a light tap operation or a heavy tap operation. Alternatively, the electronic device may determine a swipe direction of the first touch operation based on the data of the sensors in the first button, to further determine that the first touch operation is a swipe operation like a swipe-up operation, a swipe-down operation, a swipe-left operation, or a swipe-right operation.

When the type of the first touch operation is identified, the electronic device may execute a task corresponding to the first touch operation. For example, the task corresponding to the first touch operation may be remote image shooting, invoking a shortcut application, controlling music playing, or the like. In this way, the user can implement corresponding functions by performing different types of touch operations on the first button. The first button supports various user interaction modes, and can improve user experience of using the electronic device.

Not limited to the first button, the electronic device may further include more buttons.

It should be noted that the button in this application may include a physical button and a virtual button.

The physical button may include a push button and a solid-state button. A mechanical structure like an elastic element is disposed in the push button. When a finger presses the push button, the elastic element in the push button deforms, so that the button is identified as being pressed. When being pressed, the push button may provide clear button feedback, for example, making a "click" sound. The push button may also be referred to as a mechanical button. The solid-state button may be seamlessly integrated with a housing of the electronic device. In comparison with the push button, the solid-state button may make the electronic device more integrated, and reduce a gap on the electronic device, thereby improving performance such as water resistance, dust resistance, and the like of the electronic device. The physical button operation method provided in this application may be applied to the foregoing push button, or may be applied to the foregoing solid-state button.

In some embodiments, the physical button may be a button with a protrusion structure. Alternatively, the physical button may be a non-protruding button. An appearance design and a mechanical structure design of the physical button are not limited in embodiments of this application.

The virtual button may be a button like a keyboard, a back key, or a touch icon displayed on a screen of the electronic device, and may be used to simulate a function of a physical button. In comparison with the physical button, the virtual button may not need support of an entity structure, but completes an operation in a screen touching interaction mode. The electronic device may change a virtual button displayed at a position on the screen. For example, the electronic device displays an APP icon on the screen. The APP icon may be a virtual button. In response to a tap operation on the APP icon, the electronic device may display a user interface of an APP corresponding to the APP icon. The electronic device may display another virtual button, for example, a back control, at a position where the APP icon is originally displayed.

In some embodiments, one or more sensors such as the pressure sensor, the optical sensor, the bioelectric sensor, and the temperature sensor may be disposed below the screen of the electronic device. The electronic device may detect, according to the button operation method provided in this application, whether there is a touch operation on the virtual button on the screen, and a type of the touch operation on the virtual button. That the one or more sensors such as the pressure sensor, the optical sensor, the bioelectric sensor, and the temperature sensor are disposed below the screen may be equivalent to that the one or more sensors such as the pressure sensor, the optical sensor, the bioelectric sensor, and the temperature sensor are disposed in the virtual button.

The first button may be a physical button or a virtual button. In subsequent embodiments of this application, a physical button is specifically used as an example for description.

It may be understood that a button to which the button operation method in this application is applicable may be different from a conventional touchscreen button. The conventional touchscreen button may be a button provided with a touch sensor. The touch sensor may be a capacitive touch sensor or the like that is activated by touch. When a surface of the touch sensor is contacted with, a circuit inside the touch sensor is connected and a current flows. When a contact is released, the circuit inside the touch sensor is disconnected, and no current flows. For example, a touch sensor is disposed below the screen of the electronic device. A virtual button displayed on the screen may be a touchscreen button. The electronic device may detect, on the screen by using the touch sensor, a touch operation on the virtual button.

The touch sensor is easily affected by a water medium. Therefore, the conventional touchscreen button cannot be operated underwater. The one or more sensors (such as the pressure sensor, the optical sensor, the bioelectric sensor, and the temperature sensor) disposed in the button in this application are not easily affected by the water medium. Therefore, based on the button provided in this application, the user may control the electronic device underwater, for example, perform an operation on the physical button or the virtual button of the electronic device underwater.

The following describes a structure of an electronic device 100 in this application.

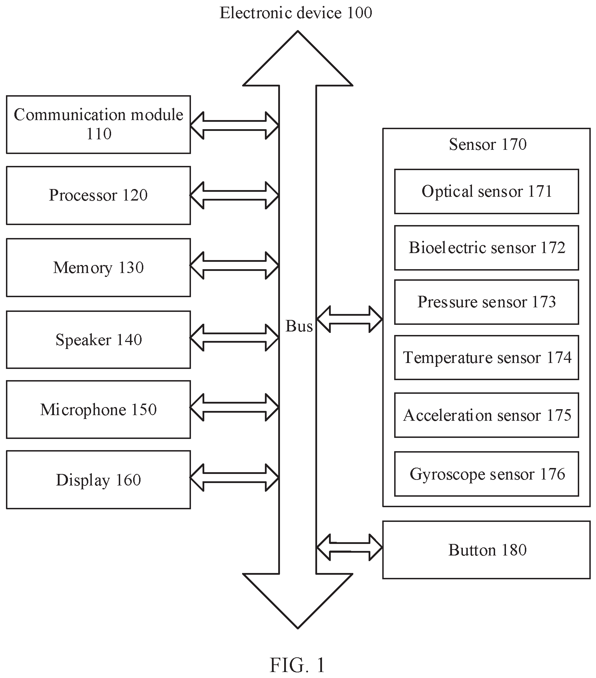

**FIG. 1** **is an example of a diagram of the structure of the electronic device 100.**

As shown in FIG. 1, the electronic device 100 may include a communication module 110, a processor 120, a memory 130, a speaker 140, a microphone 150, a display 160, a sensor 170, a button 180, and the like. These components may be coupled through a bus.

It may be understood that the structure shown in embodiments of this application does not constitute a specific limitation on the electronic device 100. In some other embodiments of this application, the electronic device 100 may include more or fewer components than those shown in the figure, or some components may be combined, or some components may be split, or different component arrangements may be used. The components shown in the figure may be implemented by hardware, software, or a combination of software and hardware.

The processor 120 may include one or more processing units. For example, the processor 120 may include an application processor (application processor, AP), a modem processor, a graphics processing unit (graphics processing unit, GPU), an image signal processor (image signal processor, ISP), a controller, a memory, a video codec, a digital signal processor (digital signal processor, DSP), a baseband processor, a neural-network processing unit (neural-network processing unit, NPU), and/or the like. Different processing units may be independent devices, or may be integrated into one or more processors. In some embodiments, the processor 120 may be a system on chip (system on chip, SOC).

The controller may be a nerve center and a command center of the electronic device 100. The controller may generate an operation control signal based on an instruction operation code and a time sequence signal, to complete control of instruction reading and instruction execution.

A memory may be further disposed in the processor 120, and is configured to store instructions and data. In some example, the memory in the processor 120 is a cache memory. The memory may store instructions or data just used or cyclically used by the processor 120. If the processor 120 needs to use the instructions or the data again, the processor may directly invoke the instructions or the data from the memory. This avoids repeated access, reduces waiting time of the processor 120, and improves system efficiency.

The communication module 110 may be configured for the electronic device 100 to receive and send information. In some embodiments, the communication module 110 may include a mobile communication module. The mobile communication module may provide a wireless communication solution that includes 2G/3G/4G/5G or the like and that is applied to the electronic device 100. The mobile communication module may include at least one filter, a switch, a power amplifier, a low noise amplifier (low noise amplifier, LNA), and the like. The mobile communication module may receive an electromagnetic wave through an antenna, perform processing such as filtering and amplification on the received electromagnetic wave, and send a processed electromagnetic wave to the modem processor for demodulation. The mobile communication module may further amplify a signal modulated by the modem processor, and convert, through the antenna, the signal into an electromagnetic wave for radiation. In some embodiments, the communication module 110 may further include a wireless communication module. The wireless communication module may provide a solution applied to the electronic device 100 for wireless communication including a wireless local area network (wireless local area network, WLAN) (for example, a wireless fidelity (wireless fidelity, Wi-Fi) network), Bluetooth (Bluetooth, BT), a global navigation satellite system (global navigation satellite system, GNSS), frequency modulation (frequency modulation, FM), a near field communication (near field communication, NFC) technology, an infrared (infrared, IR) technology, and the like. The wireless communication module may be one or more components that integrate at least one communication processing module. The wireless communication module receives an electromagnetic wave through the antenna, performs frequency modulation and filtering on an electromagnetic wave signal, and sends a processed signal to the processor 120. The wireless communication module may further receive a to-be-sent signal from the processor 120, perform frequency modulation and amplification on the signal, and convert, through the antenna, the signal into an electromagnetic wave for radiation.

The memory 130 may be configured to store computer-executable program code. The executable program code includes instructions. The processor 120 runs the instructions stored in the internal memory 130, to perform various function applications of the electronic device 100 and data processing. The internal memory 130 may include a program storage area and a data storage area. The program storage area may store an operating system, an application required by at least one function (for example, a sound playing function or an image playing function), and the like. The data storage area may store data (such as audio data and an address book) created during use of the electronic device 100, and the like. In addition, the internal memory 130 may include a highspeed random access memory, or may include a non-volatile memory, for example, at least one magnetic disk storage device, a flash memory device, or a universal flash storage (universal flash storage, UFS).

In this application, the memory 130 may store a computer program, to enable the controller or the processor 120 to implement the button operation method in this application through an interface or according to a protocol. For example, the computer program stored in the memory 130 may be used to: obtain data detected by one or more sensors such as a pressure sensor, an optical sensor, a bioelectric sensor, and a temperature sensor; determine, based on data of a sensor in a button, whether a touch operation is performed on the button; detect, based on the data of the sensor in the button, a type of the touch operation performed on the button; perform blood pressure monitoring; detect a risk of a limb control disease (for example, Parkinson's syndrome or peripheral nerve injury) of a user, and the like.

The speaker 140, also referred to as a "loudspeaker", may be configured to convert an audio electrical signal into a sound signal. The electronic device 100 may be used to listen to music or answer a call in a hands-free mode over the speaker 140.

The microphone 150, also referred to as a "mike" or a "mic", may be configured to convert a sound signal into an electrical signal.

The display 160 may be configured to display an image, a video, and the like. The display 160 may include a display panel. In some embodiments, the display 160 may further include a touch panel. The touch panel may be configured to detect a touch operation performed on the touch panel. The touch panel may transfer the detected touch operation to the application processor to determine a type of the touch event. In this way, the user may control the electronic device 100 by touching the display.

The sensor 170 may include an optical sensor 171, a bioelectric sensor 172, a pressure sensor 173, a temperature sensor 174, an acceleration sensor 175, a gyroscope sensor 176, and the like.

The optical sensor 171 may be configured to detect a photoelectric current signal. The optical sensor 171 may include an optical transmitter and an optical receiver. For example, the optical transmitter may be a light emitting diode (light emitting diode, LED). The optical receiver may be a photoelectric detector (photoelectric detector, PD). Alternatively, the optical transmitter may be a vertical cavity surface emitting laser (vertical cavity surface emitting Laser, VCSEL). The optical receiver may be a complementary metal-oxide semiconductor (complementary metal-oxide semiconductor, CMOS). The CMOS may be a one-dimensional or two-dimensional array. Types of the optical transmitter and the optical receiver are not limited in embodiments of this application. In some embodiments, the optical sensor 171 may be a PPG sensor. The PPG may implement non-invasive detection of a volume change of blood in a blood vessel through a photoelectric means. The electronic device 100 may determine a PPG signal based on a photoelectric current signal detected by the optical receiver in the PPG sensor, and further determine data such as a heart rate and blood oxygen saturation of the user based on the PPG signal.

The bioelectric sensor 172 may be configured to detect a bioelectric signal of a human body. In some embodiments, the bioelectric sensor 172 may include an ECG electrode. The electronic device 100 may detect data such as the heart rate and blood pressure of the user based on the bioelectric signal. The bioelectric signal may also be referred to as an ECG signal. In some embodiments, the electronic device 100 may detect the blood pressure of the user in combination with the PPG signal and the ECG signal. The foregoing blood pressure monitoring method is not limited in embodiments of this application.

The pressure sensor 173 may be configured to sense a pressure signal, and can convert the pressure signal into an electrical signal. In some embodiments, the pressure sensor 173 may be disposed in the display 160. The pressure sensor 173 may be further disposed in the button 180. There are a plurality of types of pressure sensors 173, such as a resistive pressure sensor, an inductive pressure sensor, and a capacitive pressure sensor. The capacitive pressure sensor may include at least two parallel plates made of conductive materials. When a force is applied to the pressure sensor 173, capacitance between electrodes changes. The electronic device 100 determines pressure data based on a change in the capacitance. The resistive pressure sensor may include a resistance strain gauge. When a force is applied to the pressure sensor 173, a resistance value of the resistance strain gauge changes with deformation of the resistance strain gauge, and is converted into a level signal. The electronic device 100 may determine pressure data based on the level signal output by the pressure sensor 173.

The temperature sensor 174 may be configured to detect temperature data. The temperature sensor 174 may include a thermistor (negative temperature coefficient, NTC). When a temperature near the temperature sensor 174 changes, a resistance value of the thermistor changes with the temperature. The electronic device 100 may determine the temperature data based on the resistance value of the thermistor. A type of the temperature sensor 174 is not limited in embodiments of this application.

The acceleration sensor 175 may detect accelerations in various directions (usually on three axes) of the electronic device 100. The acceleration sensor may detect a magnitude and a direction of gravity when the electronic device 100 is still. The acceleration sensor 175 may be further configured to identify a posture of the electronic device, and is used in an application like switching between a landscape mode and a portrait mode or a pedometer.

The gyroscope sensor 176 may be configured to determine a moving posture of the electronic device 100. In some embodiments, the electronic device 100 may determine an angular velocity of the electronic device 100 around three axes (namely, axes x, y, and z) by using the gyroscope sensor 176. The gyroscope sensor 176 may be configured to implement image stabilization during image shooting. For example, when a shutter is pressed, the gyroscope sensor 176 detects an angle at which the electronic device 100 shakes, calculates, based on the angle, a distance for which a lens module needs to compensate, and allows a lens to cancel shaking of the electronic device 100 through reverse movement, to implement image stabilization. The gyroscope sensor 176 may further be used in a navigation scenario and a somatic game scenario.

Not limited to the foregoing sensors, the electronic device 100 may further include more or fewer sensors.

The button 180 may be a physical button or a virtual button. For example, the electronic device 100 is a smartwatch, and the button 180 may be a physical button disposed on a side edge of the smartwatch. For another example, the electronic device 100 is a mobile phone, and the button 180 may be a power button, a volume adjustment button, or the like on the mobile phone. The electronic device 100 may detect a touch operation performed on the button 180, and execute a task corresponding to the touch operation performed on the button 180.

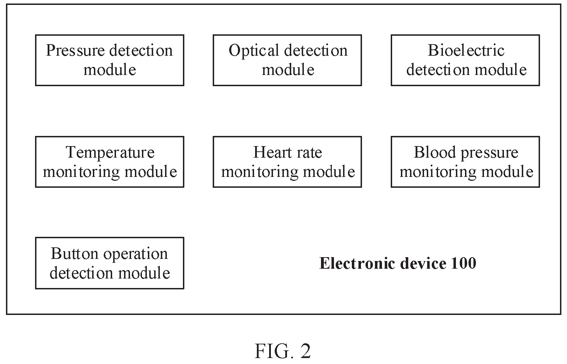

**FIG. 2** **is an example of a diagram of a structure of another electronic device 100.**

As shown in FIG. 2, the electronic device 100 includes a pressure detection module, an optical detection module, a bioelectric detection module, a temperature monitoring module, a heart rate monitoring module, a blood pressure monitoring module, and a button operation detection module. The electronic device 100 may further include a first button.

The button operation detection module may be configured to detect whether a touch operation is performed on a button (for example, the first button) of the electronic device 100, and a type of the touch operation performed on the button. For example, the type of the touch operation performed on the button may include but is not limited to: a tap operation, a touch and hold operation, a light tap operation, a heavy tap operation, a swipe-up operation, a swipe-down operation, a swipe-left operation, a swipe-right operation, an operation of swiping diagonally down to the left, an operation of swiping diagonally down to the right, an operation of swiping diagonally up to the left, an operation of swiping diagonally up to the right, two consecutive tap operations, and a tap operation and a touch and hold operation that are consecutive.

The pressure detection module may include the pressure sensor 173 shown in FIG. 1. For example, the pressure detection module may include a pressure sensor disposed in the first button. When a finger of a user presses the first button, the pressure detection module may detect pressure data of a touch operation performed on the first button. In some embodiments, the pressure detection module may send the detected pressure data to the button operation detection module. Based on the pressure data, the button operation detection module may detect whether there is a touch operation on the first button. If there is a touch operation on the first button, the button operation detection module may detect, based on the pressure data, one or more pieces of data such as a pressing position, pressing time, a press force, and a pressing quantity of the touch operation, to determine a type of the touch operation performed on the first button. For example, the button operation detection module may detect whether the pressure data is greater than a first pressure threshold. If the pressure data is greater than the first pressure threshold, the touch operation is performed on the first button. Further, the button operation detection module may determine duration in which the first button is pressed through the touch operation, to determine that the touch operation performed on the first button is a touch and hold operation or a tap operation.

The optical detection module may include the optical sensor 171 shown in FIG. 1. For example, the optical detection module may include an optical sensor disposed in the first button. When the finger of the user presses the first button, a photoelectric current signal detected by the optical detection module changes. In some embodiments, the optical detection module may send the detected photoelectric current signal to the button operation detection module. Based on the photoelectric current signal, the button operation detection module may detect whether there is a touch operation on the first button. If there is a touch operation on the first button, the button operation detection module may detect, based on the photoelectric current signal, one or more pieces of data such as a pressing position, pressing time, a press force, and a pressing quantity of the touch operation, to determine a type of the touch operation performed on the first button.

The bioelectric detection module may include the bioelectric sensor 172 shown in FIG. 1. For example, the bioelectric detection module may include a bioelectric sensor disposed in the first button. The bioelectric detection module may further include another bioelectric sensor in the electronic device 100. A position of the another bioelectric sensor may be in another area other than the first button. For example, the electronic device 100 is a smartwatch. The first button is a side button of the smartwatch. A bioelectric sensor is disposed in the first button. Another bioelectric sensor is further disposed on a bottom wall of the smartwatch. When the smartwatch is in a worn state, the bioelectric sensor disposed on the bottom wall is close to the skin of the user, and can detect a bioelectric signal. When the finger of the user presses the first button, the bioelectric sensor disposed in the first button can also detect a bioelectric signal. In this case, the bioelectric sensor disposed on the bottom wall and the bioelectric sensor disposed in the first button are in a connected state. The bioelectric detection module may send the detected bioelectric signal to the button operation detection module. Based on the bioelectric signal, the button operation detection module may detect whether there is a touch operation on the first button. If there is a touch operation performed on the first button, the button operation detection module may detect, based on the bioelectric signal, one or more pieces of data such as a pressing position, pressing time, and a pressing quantity of the touch operation.

The temperature monitoring module may include the temperature sensor 174 shown in FIG. 1. For example, the temperature monitoring module may include a temperature sensor disposed in the first button. When the finger of the user presses the first button, the temperature monitoring module may detect a temperature change. In some embodiments, the temperature monitoring module may send the detected temperature data to the button operation detection module. Based on the temperature data, the button operation detection module may detect whether there is a touch operation on the first button.

The heart rate monitoring module may be configured to detect a heart rate of the user. In some embodiments, the optical detection module may send the photoelectric current signal to the heart rate monitoring module. The bioelectric detection module may also send the bioelectric signal to the heart rate monitoring module. The heart rate monitoring module may determine the heart rate of the user based on the photoelectric current signal and/or the bioelectric signal.

The blood pressure monitoring module may be configured to detect blood pressure of the user. In some embodiments, the optical detection module may send the photoelectric current signal to the blood pressure monitoring module. The bioelectric detection module may also send the bioelectric signal to the blood pressure monitoring module. The blood pressure monitoring module may determine the blood pressure of the user based on the photoelectric current signal and the bioelectric signal.

Not limited to the modules shown in FIG. 2, the electronic device 100 may include more or fewer modules than those shown in FIG. 2, or some modules may be combined, or some modules may be split.

The electronic device 100 in this application may be a wearable device like a smartwatch, a smart band, or a headset, or may be a mobile phone, a tablet computer, a notebook computer, an ultra-mobile personal computer (ultra-mobile personal computer, UMPC), a netbook, a personal digital assistant (personal digital assistant, PDA), or the like. A specific type of the electronic device 100 is not limited in embodiments of this application.

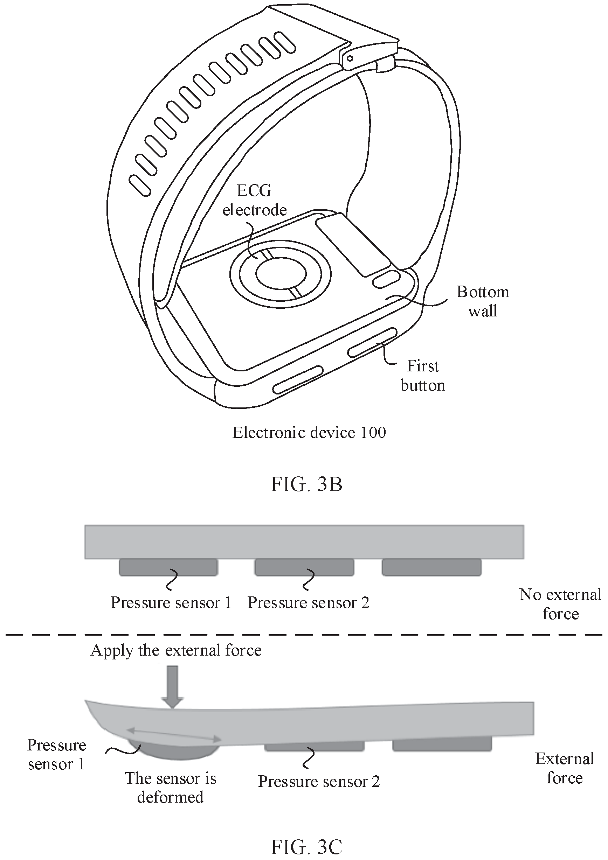

**FIG. 3A** **and** **FIG. 3B** **are examples of diagrams of a button according to this application.**

As shown in FIG. 3A, a button of the electronic device 100 may include a first button. For example, the first button may be a physical button disposed on a side edge of the electronic device 100. A position of the first button is not limited in embodiments of this application.

In some embodiments, a pressure sensor, a bioelectric sensor, an optical sensor, and a temperature sensor may be disposed in the first button. The optical sensor may include an optical transmitter and an optical receiver shown in FIG. 3A. The optical transmitter may also be referred to as a light emitting device. The optical receiver may also be referred to as a light receiving device. The bioelectric sensor may include an ECG electrode shown in FIG. 3A. The pressure sensor and the optical sensor may be disposed inside the first button. The temperature sensor and the ECG electrode may be disposed on a touch surface of the first button. When a finger of a user touches the first button, the temperature sensor may detect a temperature of the finger of the user, and the ECG electrode may generate a bioelectric signal.

The touch surface of the first button may further include a light transmission area 1 and a light transmission area 2 shown in FIG. 3A. The light transmission area 1 may be located at a position corresponding to the optical transmitter on the first button. The light transmission area 2 may be located at a position corresponding to the optical receiver on the first button. An optical signal transmitted by the optical transmitter may be propagated through the light transmission area 1. After being reflected, scattered, and absorbed, the optical signal may be transmitted through the light transmission area 2 and be received by the optical receiver. The ECG electrode may be disposed on a periphery of the light transmission area 1 and the light transmission area 2. When the finger of the user covers the light transmission area 2, the optical receiver may receive an optical signal that is absorbed, reflected, and scattered by a human body tissue (for example, human skin, blood, a muscle, and a bone).

It can be learned from FIG. 3A that the first button may be a physical button with a specific length. The position corresponding to the optical sensor on the first button may occupy only a partial area of the touch surface of the first button. For example, the light transmission area 1 and the light transmission area 2 are located in a lower half area of the first button. When the finger of the user presses an area other than the light transmission area 1 and the light transmission area 2 on the first button, an optical signal received by the optical receiver is an optical signal that is not absorbed, reflected, or scattered by the human tissue, and cannot be used to detect health data such as a heart rate and blood pressure of the user. Therefore, when health data detection such as blood pressure monitoring is performed, the electronic device 100 may determine whether a position at which the finger of the user is placed on the first button is appropriate, and prompt the user to adjust the finger position when the position at which the finger of the user is placed is inappropriate, to improve accuracy of detecting health data such as blood pressure. A method for determining whether the position at which the finger of the user is placed on the first button is appropriate during blood pressure monitoring is described in a subsequent embodiment. Details are not described herein.

The optical sensor in the first button may include one or more optical receivers and one or more light transmitters. The first button may include one or more pressure sensors.

Optionally, the temperature sensor may alternatively be disposed inside the first button. For example, the temperature sensor may be further disposed near the pressure sensor. In this way, the temperature sensor may detect a temperature of an environment in which the pressure sensor is located. A sudden temperature change may cause a large change in a pressure reading of the pressure sensor. Pressure data may be inaccurate. The electronic device 100 may correct the pressure data based on the temperature detected by the temperature sensor, to reduce an error of the pressure data.

Positions of the temperature sensor, the ECG electrode, the optical receiver, the light transmitter, and the pressure sensor in the first button shown in FIG. 3A are merely examples for description in this application, and should not constitute a limitation on this application. Not limited to the pressure sensor, the bioelectric sensor, the optical sensor, and the temperature sensor, the first button may be provided with more or fewer sensors.

In the electronic device 100, in addition to the bioelectric sensor disposed in the first button, one or more bioelectric sensors may be further disposed at another position other than the first button.

As shown in FIG. 3B, the electronic device 100 may be a smartwatch, and an ECG electrode may be disposed on a bottom wall of the electronic device 100. When the electronic device 100 is in a worn state, the ECG electrode disposed on the bottom wall may detect a bioelectric signal. If the user places the finger on the first button, the ECG electrode in the first button may also detect a bioelectric signal. When the ECG electrode in the first button and the ECG electrode disposed on the bottom wall detect bioelectric signals at the same time, the electronic device 100 may determine that the ECG electrode in the first button and the ECG electrode disposed on the bottom wall are in a connected state.

**FIG. 3C** **is an example of a diagram of a pressure sensor disposed in a first button under an external force.**

One or more pressure sensors may be disposed in the first button. For example, the pressure sensors disposed in the first button may include a pressure sensor 1 and a pressure sensor 2 shown in FIG. 3C. The pressure sensor 1 and the pressure sensor 2 may be resistive pressure sensors. The pressure sensor 1 and the pressure sensor 2 each may include a resistance strain gauge.

As shown in FIG. 3C, when no external force is performed on the first button, neither the pressure sensor 1 nor the pressure sensor 2 is deformed. When an external force is performed on the first button, the pressure sensor disposed in the first button is deformed. For example, if the external force is performed on a position corresponding to the pressure sensor 1 on the first button, the pressure sensor 1 is deformed. The position to which the external force is applied is close to a position corresponding to the pressure sensor 2. Therefore, the pressure sensor 2 is also deformed. It can be learned from FIG. 3C that deformation of the pressure sensor 1 is greater than deformation of the pressure sensor 2. A larger external force applied to a pressure sensor indicates larger deformation of the pressure sensor, and therefore, indicates larger pressure data detected by the pressure sensor. In other words, the electronic device 100 may determine, based on the pressure data of the pressure sensor in the first button, a detected press force of a touch operation performed on the first button.

In addition, when the external force is continuously applied, the resistive pressure sensor continuously maintains deformation. Therefore, the electronic device 100 may determine, based on the pressure data, a moment at which the touch operation is performed on the first button and pressing duration of the touch operation. When there are a plurality of times of external forces applied to the first button, the resistive pressure sensor generates deformation a plurality of times. Therefore, the electronic device 100 may determine, based on the pressure data, a quantity of times that the first button is pressed in a time period.

It can be learned that, when a plurality of pressure sensors are disposed in the first button, the electronic device 100 may determine, based on pressure data detected by the plurality of pressure sensors, a pressing position of the touch operation on the first button.

Not limited to the resistive pressure sensor, the pressure sensor in the first button may further be another type of pressure sensor. Based on the pressure data detected by the another type of pressure sensor, the electronic device 100 may also detect one or more pieces of data such as a press force, a pressing moment, pressing duration, a pressing quantity, and a pressing position of a touch operation performed on the first button.

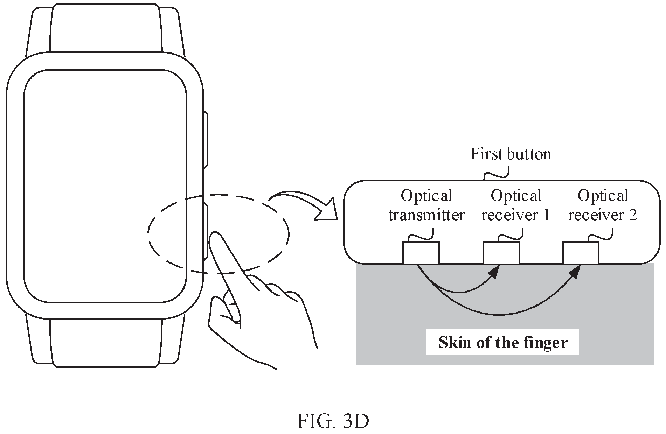

**FIG. 3D** **is an example of a diagram of detecting a photoelectric current signal by an optical sensor in a first button.**

The optical sensor is disposed in the first button. The optical sensor may include an optical transmitter and an optical receiver. The optical sensor may include one or more optical receivers. For example, the optical sensor may include an optical receiver 1 and an optical receiver 2 shown in FIG. 3D. The optical transmitter may transmit an optical signal. The optical receiver 1 and the optical receiver 2 may receive a reflected or scattered optical signal, and generate a photoelectric current signal based on the received optical signal.

When a finger touches the first button and covers positions corresponding to the optical transmitter, the optical receiver 1, and the optical receiver 2, the optical signal transmitted by the optical transmitter may be absorbed, reflected, and scattered by a tissue like skin of the finger, blood in a blood vessel in the finger, a muscle, or a bone. Amounts of optical signals received by the optical receiver 1 and the optical receiver 2 after the finger touches the first button are different from amounts of optical signals received by the optical receiver and the optical receiver 2 when the first button is not touched by the finger. In comparison with a case in which the first button is not touched by the finger, in a case in which the finger touches the first button, amounts of optical signals received by the optical receiver 1 and the optical receiver 2 increase. Therefore, when a touch operation is performed on the first button, a signal strength of the photoelectric current signal detected by the optical sensor in the first button increases.

In addition, a volume of blood in a blood vessel changes in a process of cardiac relaxation and contraction, and an optical signal absorbed by blood in the blood vessel also changes. Therefore, when the finger touches the first button, the amounts of optical signals received by the optical receiver 1 and the optical receiver 2 change with cardiac contraction and relaxation. In other words, the signal strength of the photoelectric current signal detected by the optical sensor in the first button changes with cardiac contraction and relaxation.

It can be learned that when the touch operation is continuously performed on the first button, the optical receiver in the optical sensor continuously receives an optical signal absorbed, reflected, and scattered by the human body tissue (such as human skin, blood, a muscle, or a bone), and the strength of the photoelectric current signal detected by the optical sensor continuously remains in a high state. Therefore, the electronic device 100 may determine, based on the photoelectric current signal, a moment at which the touch operation is performed on the first button and pressing duration of the touch operation. When a user touches the first button a plurality of times, the strength of the photoelectric current signal detected by the optical sensor increases and then decreases the plurality of times. Therefore, the electronic device 100 may determine, based on the photoelectric current signal, a quantity of times that the first button is pressed in a time period.

In some embodiments, a plurality of optical receivers are disposed in the optical sensor, for example, the optical receiver 1 and the optical receiver 2 shown in FIG. 3D. When a position corresponding to the optical receiver 1 on the first button is touched by the finger before a position corresponding to the optical receiver 2 on the first button, the optical receiver 1 may receive, before the optical receiver 2, the optical signal absorbed, reflected, and scattered by the human body tissue. In other words, an amount of the optical signal received by the optical receiver 1 increases earlier than that of an amount of the optical signal received by the optical receiver 2. The optical signal that is received by the optical receiver 1 and that can reflect a heart rate of the user has a phase lead relative to the optical signal that is received by the optical receiver 2 and that can reflect the heart rate of the user. Therefore, the electronic device 100 may determine a pressing position of the touch operation on the first button based on photoelectric current signals detected by the plurality of optical receivers.

In some embodiments, as the press force of the touch operation on the first button changes, the photoelectric current signal detected by the optical sensor also changes accordingly. A smaller press force of the touch operation on the first button indicates a smoother waveform of the photoelectric current signal, and a weaker signal strength of the photoelectric current signal. A larger press force of the touch operation on the first button indicates a sharper waveform of the photoelectric current signal, and a stronger signal strength of the photoelectric current signal. Therefore, the electronic device 100 may determine the press force of the touch operation on the first button based on the photoelectric current signal.

In some embodiments, the electronic device 100 may detect, in combination with a plurality of sensors disposed in the first button, whether a touch operation is performed on the first button.

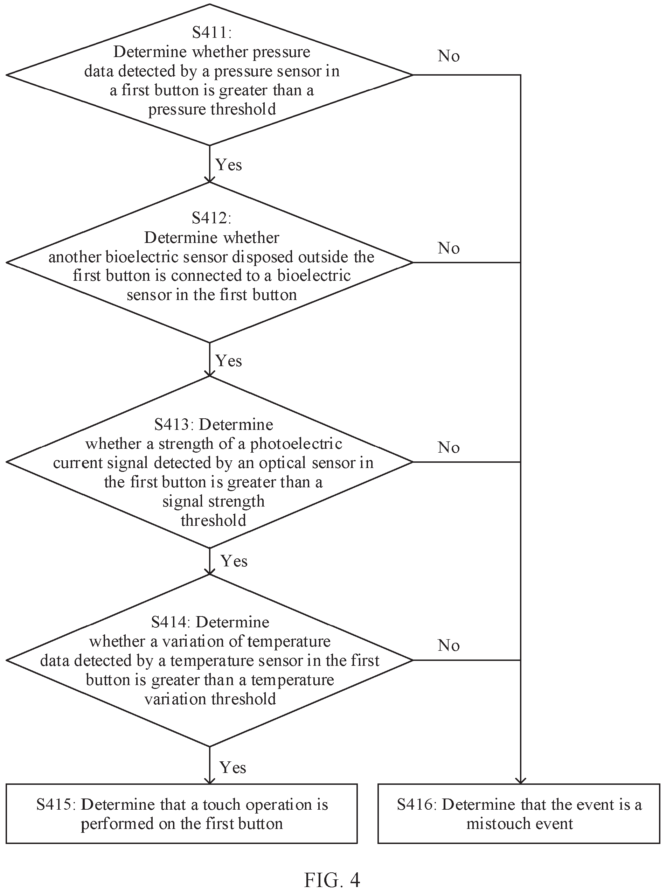

**FIG. 4** **is an example of a button mistouch detection method.**

A sensor disposed in the first button may include a pressure sensor, a bioelectric sensor, an optical sensor, and a temperature sensor. As shown in FIG. 4, the mistouch detection method may include step S411 to step S416.

S411: Determine whether pressure data detected by the pressure sensor in the first button is greater than a pressure threshold.

When an external force is applied to the first button, the pressure data detected by the pressure sensor in the first button changes. In comparison with a case in which the first button is unintentionally touched or is affected by an ambient temperature change, in a case in which a touch operation is performed on the first button, the pressure data detected by the pressure sensor is more stable, and is greater than the preset pressure threshold in a time period in which the touch operation is performed. The electronic device 100 may determine, by determining whether the pressure data is greater than the pressure threshold, a case in which no touch operation is performed on the first button.

If the pressure data detected by the pressure sensor in the first button is less than or equal to the pressure threshold, the electronic device 100 may perform step S416. In other words, the electronic device 100 may determine that no touch operation is performed on the first button.

In some embodiments, the pressure data used for mistouch detection may be detected by the pressure sensor in the first button within a time period. For example, the time period may be 100 milliseconds (ms), 200 ms, or the like. If the pressure data in the time period is greater than the pressure threshold, the electronic device 100 may perform step S416. In this way, impact of a sudden change of the pressure data caused by an unintentional touch or an ambient temperature change on the first button on accuracy of the mistouch detection can be alleviated.

In some embodiments, only one pressure sensor is disposed in the first button. In this case, the pressure data may be detected by the only one pressure sensor in the first button. Alternatively, a plurality of pressure sensors are disposed in the first button. In this case, the pressure data may include pressure data detected by one or more pressure sensors of the plurality of pressure sensors. For example, a pressure sensor 1 and a pressure sensor 2 are disposed in the first button. Pressure data detected by the pressure sensor 1 in a time period of 0 to 50 ms is greater than the pressure threshold, and pressure data detected in a time period of 51 to 100 ms is less than the pressure threshold. Pressure data detected by the pressure sensor 2 in the time period of 0 to 50 ms is less than the pressure threshold, and pressure data detected in the time period of 51 to 100 ms is greater than the pressure threshold. The foregoing case may indicate that pressure data detected by the pressure sensor in the first button in a time period of 0 to 100 ms is greater than the pressure threshold.

A value of the pressure threshold is not limited in this application. The pressure threshold may be referred to as a first pressure threshold.

If the pressure data is greater than the pressure threshold, the electronic device 100 may perform the following step S412. In this way, whether a touch operation is performed on the first button may be more accurately determined in combination with the bioelectric sensor in the first button.

S412: Determine whether another bioelectric sensor disposed outside the first button is connected to the bioelectric sensor in the first button.

In some embodiments, the another bioelectric sensor disposed outside the first button may be a bioelectric sensor disposed on a bottom wall of the electronic device 100 (refer to FIG. 3B). A position of the another bioelectric sensor is not limited in embodiments of this application. When both the another bioelectric sensor and the bioelectric sensor in the first button are in contact with skin of a user, the another bioelectric sensor and the bioelectric sensor in the first button each can detect a bioelectric signal. In other words, the another bioelectric sensor is connected to the bioelectric sensor in the first button.

For example, the electronic device 100 is a smartwatch. A bioelectric sensor is disposed on a bottom wall of the smartwatch. When the smartwatch is in a worn state, the bioelectric sensor disposed on the bottom wall of the smartwatch may detect a bioelectric signal. When a touch operation is performed on the first button, the bioelectric sensor in the first button may detect a bioelectric signal. Therefore, that the bioelectric sensor disposed on the bottom wall of the smartwatch is connected to the bioelectric sensor in the first button may indicate that a touch operation is performed on the first button.

If the another bioelectric sensor is not connected to the bioelectric sensor in the first button, the electronic device 100 may perform the following step S416.

If the another bioelectric sensor is connected to the bioelectric sensor in the first button, the electronic device 100 may perform the following step S413. This can further combine the optical sensor in the first button with the pressure sensor and the bioelectric sensor, to more accurately determine whether a touch operation is performed on the first button.

It should be noted that time at which the pressure data is collected in step S411 and time at which the bioelectric signal used to determine that bioelectric sensors are connected is collected in step S412 may be the same or similar. The same or similar time may include two time periods that are completely the same, and two time periods that are interleaved and have an intersection. In other words, both the pressure sensor and the bioelectric sensor in the first button may collect data in real time. When it is determined that the pressure data detected by the pressure sensor in the first button is greater than the pressure threshold, the electronic device 100 may obtain a bioelectric signal detected by the bioelectric sensor in the first button in a time period in which the pressure data greater than the pressure threshold is detected. In this way, the electronic device 100 may determine whether two conditions that the pressure sensor in the first button detects the pressure data greater than the pressure threshold and that the bioelectric sensor in the first button is connected to the another bioelectric sensor are met at the same time. It may be understood that, when the two conditions are met at the same time, it can more accurately indicate that a touch operation is performed on the first button.

S413: Determine whether a strength of the photoelectric current signal detected by the optical sensor in the first button is greater than a signal strength threshold.

Because a signal strength of the photoelectric current signal when a touch operation is performed on the first button is greater than a signal strength of the photoelectric current signal when no touch operation is performed on the first button, the electronic device 100 may determine, by determining whether the strength of the photoelectric current signal is greater than the signal strength threshold, whether the touch operation is performed on the first button. A value of the signal strength threshold is not limited in embodiments of this application. The signal strength threshold may be referred to as a first signal strength threshold.

If the strength of the photoelectric current signal is less than or equal to the signal strength threshold, the electronic device 100 may perform the following step S416.

If the strength of the photoelectric current signal is greater than the signal strength threshold, the electronic device 100 may perform the following step S414. This can further combine the temperature sensor in the first button with the pressure sensor, the bioelectric sensor, and the optical sensor to more accurately determine whether a touch operation is performed on the first button.

In some embodiments, the optical sensor in the first button may include only one optical receiver. The strength of the photoelectric current signal may be determined by the optical sensor based on an optical signal received by the only one optical receiver of the optical sensor. Alternatively, the optical sensor in the first button may include a plurality of optical receivers. The strength of the photoelectric current signal may be determined by the optical sensor based on an optical signal received by one or more optical receivers of the plurality of optical receivers of the optical sensor. It may be understood that amounts of optical signals received by the plurality of optical receivers may change with a position at which the touch operation is performed on the first button. When it is determined, based on optical signals received by the plurality of optical receivers in a plurality of different time periods, that strengths of photoelectric current signals are greater than the signal strength threshold, the electronic device 100 may determine that the strengths of the photoelectric current signals detected by the optical sensor in the first button in the plurality of different time periods is greater than the signal strength threshold.

It should be noted that the time at which the strength of the photoelectric current signal is collected in step S413 may be the same as or similar to the time at which the pressure data is collected in step S411 and the time at which the bioelectric signal used to determine that the bioelectric sensors are connected is collected in step S412. In other words, the pressure sensor, the bioelectric sensor, and the optical sensor in the first button each may collect data in real time. When it is determined that the pressure data detected by the pressure sensor in the first button is greater than the pressure threshold, and the bioelectric sensor in the first button is connected to the another bioelectric sensor, the electronic device 100 may obtain a photoelectric current signal detected by the optical sensor in the first button in the time period in which the pressure data greater than the pressure threshold is detected or in a time period in which the foregoing bioelectric sensors are connected. In this way, the electronic device 100 may determine whether the following three conditions are met at the same time: the pressure sensor in the first button detects the pressure data greater than the pressure threshold, the bioelectric sensor in the first button is connected to the another bioelectric sensor, and the strength of the photoelectric current signal detected by the optical sensor in the first button is greater than the signal strength threshold. It may be understood that, when the three conditions are met at the same time, it can more accurately indicate that a touch operation is performed on the first button.

S414: Determine whether a variation of temperature data detected by the temperature sensor in the first button is greater than a temperature variation threshold.

When a finger touches the first button, the temperature data detected by the temperature sensor in the first button changes due to a temperature of the finger. The electronic device 100 may obtain temperature data detected by the temperature sensor in the first button in a time period, and determine whether a variation of the temperature data in the time period is greater than the temperature variation threshold. The variation of the temperature data in the time period may be a difference between temperature data at start time and temperature data at end time in the time period. Alternatively, the variation of the temperature data in the time period may be a difference between the largest piece of temperature data and the smallest piece of temperature data in the time period. A method for calculating the variation of the temperature data in the time period is not limited in embodiments of this application.

If the variation of the temperature data is less than or equal to the temperature variation threshold, the electronic device 100 may perform the following step S416.

If the variation of the temperature data is greater than the temperature variation threshold, the electronic device 100 may perform the following step S415.

It should be noted that time at which the temperature data is collected in step S414, the time at which the pressure data is collected in step S411, the time at which the bioelectric signal used to determine that the bioelectric sensors are connected is collected in step S412, and the time at which the strength of the photoelectric current signal is collected in step S413 may be the same or similar. In other words, the pressure sensor, the bioelectric sensor, the optical sensor, and the temperature sensor in the first button each may collect data in real time. When it is determined that the pressure data detected by the pressure sensor in the first button is greater than the pressure threshold, the bioelectric sensor in the first button is connected to the another bioelectric sensor, and the strength of the photoelectric current signal detected by the optical sensor in the first button is greater than the signal strength threshold, the electronic device 100 may obtain temperature data detected by the temperature sensor in the first button in the time period in which the pressure data greater than the pressure threshold is detected, or in the time period in which the bioelectric sensors are connected, or in a time period in which the photoelectric current signal whose signal strength is greater than the signal strength threshold is detected. In this way, the electronic device 100 may determine whether the following four conditions are met at the same time: the pressure sensor in the first button detects the pressure data greater than the pressure threshold, the bioelectric sensor in the first button is connected to the another bioelectric sensor, the strength of the photoelectric current signal detected by the optical sensor in the first button is greater than the signal strength threshold, and the variation of the temperature data detected by the temperature sensor in the first button is greater than the temperature variation threshold. It is understood that, when the four conditions are met at the same time, it can more accurately indicate that a touch operation is performed on the first button.

S415: Determine that the touch operation is performed on the first button.

S416: Determine that the event is a mistouch event.

An execution sequence of step S411 to step S414 is not limited in embodiments of this application. Steps S411 to S414 may be simultaneously performed by the electronic device 100, or may be sequentially performed in a preset sequence. For example, the electronic device 100 may first perform step S412, or may first perform step S413, or may first perform step S414. Optionally, the electronic device 100 may first perform one or more steps of step S411 to step S414, and then simultaneously perform the remaining steps of step S411 to step S414. Alternatively, the electronic device 100 may first simultaneously perform one or more steps of step S411 to step S414, and then sequentially perform the remaining steps of step S411 to step S414 in a preset sequence.

One or more steps in the foregoing step S411 to step S414 are optional. When at least two of the following four conditions are met: the pressure sensor in the first button detects the pressure data greater than the pressure threshold, the bioelectric sensor in the first button is connected to the another bioelectric sensor, the strength of the photoelectric current signal detected by the optical sensor in the first button is greater than the signal strength threshold, and the variation of the temperature data detected by the temperature sensor in the first button is greater than the temperature variation threshold, the electronic device 100 may determine that a touch operation is performed on the first button.

In some embodiments, the mistouch detection method may not include step S414. In other words, the electronic device 100 may detect, by using the pressure sensor, the bioelectric sensor, and the optical sensor in the first button, whether a touch operation is performed on the first button. The electronic device 100 may perform step S411 to step S413. When the following three conditions are met at the same time: the pressure sensor in the first button detects the pressure data greater than the pressure threshold, the bioelectric sensor in the first button is connected to the another bioelectric sensor, and the strength of the photoelectric current signal detected by the optical sensor in the first button is greater than the signal strength threshold, the electronic device 100 may determine that a touch operation is performed on the first button. Otherwise, if any one of the three conditions is not met, the electronic device 100 may determine that no touch operation is performed on the first button.

In some embodiments, the mistouch detection method may not include step S413. In other words, the electronic device 100 may detect, by using the pressure sensor, the bioelectric sensor, and the temperature sensor in the first button, whether a touch operation is performed on the first button. The electronic device 100 may perform step S411, step S412, and step S414. When the following three conditions are met at the same time: the pressure sensor in the first button detects the pressure data greater than the pressure threshold, the bioelectric sensor in the first button is connected to the another bioelectric sensor, and the variation of the temperature data detected by the temperature sensor in the first button is greater than the temperature variation threshold, the electronic device 100 may determine that a touch operation is performed on the first button. Otherwise, if any one of the three conditions is not met, the electronic device 100 may determine that no touch operation is performed on the first button.

In some embodiments, the mistouch detection method may not include step S412. In other words, the electronic device 100 may detect, by using the pressure sensor, the optical sensor, and the temperature sensor in the first button, whether a touch operation is performed on the first button. The electronic device 100 may perform step S411, step S413, and step S414. When the following three conditions are met at the same time: the pressure sensor in the first button detects the pressure data greater than the pressure threshold, the strength of the photoelectric current signal detected by the optical sensor in the first button is greater than the signal strength threshold, and the variation of the temperature data detected by the temperature sensor in the first button is greater than the temperature variation threshold, the electronic device 100 may determine that a touch operation is performed on the first button. Otherwise, if any one of the three conditions is not met, the electronic device 100 may determine that no touch operation is performed on the first button.

In some embodiments, the mistouch detection method may not include step S411. In other words, the electronic device 100 may detect, by using the bioelectric sensor, the optical sensor, and the temperature sensor in the first button, whether a touch operation is performed on the first button. The electronic device 100 may perform step S412 to step S414. When the following three conditions are met at the same time: the bioelectric sensor in the first button is connected to the another bioelectric sensor, the strength of the photoelectric current signal detected by the optical sensor in the first button is greater than the signal strength threshold, and the variation of the temperature data detected by the temperature sensor in the first button is greater than the temperature variation threshold, the electronic device 100 may determine that a touch operation is performed on the first button. Otherwise, if any one of the three conditions is not met, the electronic device 100 may determine that no touch operation is performed on the first button.

In some embodiments, the mistouch detection method may not include step S413 and step S414. The electronic device 100 may detect, by using the pressure sensor and the bioelectric sensor in the first button, whether a touch operation is performed on the first button. In other words, the electronic device 100 may perform step S411 and step S412. When the following two conditions are met at the same time: the pressure sensor in the first button detects the pressure data greater than the pressure threshold and the bioelectric sensor in the first button is connected to the another bioelectric sensor, the electronic device 100 may determine that a touch operation is performed on the first button. Otherwise, if any one of the two conditions is not met, the electronic device 100 may determine that no touch operation is performed on the first button.

In some embodiments, the mistouch detection method may not include step S412 and step S414. The electronic device 100 may detect, by using the pressure sensor and the optical sensor in the first button, whether a touch operation is performed on the first button. In other words, the electronic device 100 may perform step S411 and step S413. When the following two conditions are met at the same time: the pressure sensor in the first button detects the pressure data greater than the pressure threshold, and the strength of the photoelectric current signal detected by the optical sensor in the first button is greater than the signal strength threshold, the electronic device 100 may determine that a touch operation is performed on the first button. Otherwise, if any one of the two conditions is not met, the electronic device 100 may determine that no touch operation is performed on the first button.

In some embodiments, the mistouch detection method may not include step S412 and step S413. The electronic device 100 may detect, by using the pressure sensor and the temperature sensor in the first button, whether a touch operation is performed on the first button. In other words, the electronic device 100 may perform step S411 and step S414. When the following two conditions are met at the same time: the pressure sensor in the first button detects the pressure data greater than the pressure threshold, and the variation of the temperature data detected by the temperature sensor in the first button is greater than the temperature variation threshold, the electronic device 100 may determine that a touch operation is performed on the first button. Otherwise, if any one of the two conditions is not met, the electronic device 100 may determine that no touch operation is performed on the first button.

In some embodiments, the mistouch detection method may not include step S411 and step S414. The electronic device 100 may detect, by using the optical sensor and the bioelectric sensor in the first button, whether a touch operation is performed on the first button. In other words, the electronic device 100 may perform step S412 and step S413. When the following two conditions are met at the same time: the bioelectric sensor in the first button is connected to the another bioelectric sensor, and the strength of the photoelectric current signal detected by the optical sensor in the first button is greater than the signal strength threshold, the electronic device 100 may determine that a touch operation is performed on the first button. Otherwise, if any one of the two conditions is not met, the electronic device 100 may determine that no touch operation is performed on the first button.

In some embodiments, the mistouch detection method may not include step S411 and step S412. The electronic device 100 may detect, by using the optical sensor and the temperature sensor in the first button, whether a touch operation is performed on the first button. In other words, the electronic device 100 may perform step S413 and step S414. When the following two conditions are met at the same time: the strength of the photoelectric current signal detected by the optical sensor in the first button is greater than the signal strength threshold, and the variation of the temperature data detected by the temperature sensor in the first button is greater than the temperature variation threshold, the electronic device 100 may determine that a touch operation is performed on the first button. Otherwise, if any one of the two conditions is not met, the electronic device 100 may determine that no touch operation is performed on the first button.

In some embodiments, the mistouch detection method may not include step S411 and step S413. The electronic device 100 may detect, by using the bioelectric sensor and the temperature sensor in the first button, whether a touch operation is performed on the first button. In other words, the electronic device 100 may perform step S412 and step S414. When the following two conditions are met at the same time: the bioelectric sensor in the first button is connected to the another bioelectric sensor, and the variation of the temperature data detected by the temperature sensor in the first button is greater than the temperature variation threshold, the electronic device 100 may determine that a touch operation is performed on the first button. Otherwise, if any one of the two conditions is not met, the electronic device 100 may determine that no touch operation is performed on the first button.

It can be learned from the foregoing method that the electronic device 100 may detect, in combination with at least two types of sensors in the first button, whether a touch operation is performed on the first button. This can reduce cases of incorrectly determining a button-press behavior of the user through only a single type of sensor. The foregoing method can reduce cases in which a mistouch on the button is identified as a touch operation of the user, and more accurately identify a touch operation performed on the button.

In some embodiments, when it is determined that a touch operation is performed on the first button, the electronic device 100 may further identify a type of the touch operation. The type of the touch operation may include a press operation, a swipe operation, and the like. Then, the electronic device 100 may execute, based on the type of the touch operation, a task corresponding to the touch operation. The electronic device 100 may identify the type of the touch operation based on one or more of the pressure data, the photoelectric current signal, and the bioelectric signal. For example, when the sensors used to determine that the touch operation is performed on the first button includes the pressure sensor, the electronic device 100 may identify the type of the touch operation based on the pressure data detected by the pressure sensor. When the sensors used to determine that the touch operation is performed on the first button includes the optical sensor, the electronic device 100 may identify the type of the touch operation based on the photoelectric current signal detected by the optical sensor. When the sensor used to determine that the touch operation is performed on the first button includes the bioelectric sensor, the electronic device 100 may identify the type of the touch operation based on the bioelectric signal detected by the bioelectric sensor.

The following specifically describes a method for detecting the type of the touch operation provided in this application.

In some embodiments, the electronic device 100 may detect, by using the pressure sensor disposed in the first button, the type of the touch operation performed on the first button.

**FIG. 5** **is an example of a diagram of position distribution of pressure sensors in a first button.**

As shown in FIG. 5, the pressure sensors disposed in the first button may include a pressure sensor 1, a pressure sensor 2, a pressure sensor 3, a pressure sensor 4, a pressure sensor 5, and a pressure sensor 6. The pressure sensor 1 to the pressure sensor 6 may be arranged in three rows and two columns. The pressure sensor 1 and the pressure sensor 2 may be distributed in a first row. The pressure sensor 3 and the pressure sensor 4 may be distributed in a second row, and are respectively located in an area 3 and an area 4. The pressure sensor 5 and the pressure sensor 6 may be distributed in a third row, and are respectively located in an area 5 and an area 6. A position corresponding to the pressure sensor 1 on the first button may be located in an area 1. A position corresponding to the pressure sensor 2 on the first button may be located in an area 2. A position corresponding to the pressure sensor 3 on the first button may be located in the area 3. A position corresponding to the pressure sensor 4 on the first button may be located in the area 4. A position corresponding to the pressure sensor 5 on the first button may be located in the area 5. A position corresponding to the pressure sensor 6 on the first button may be located in the area 6. The area 1 to the area 6 may be areas on a touch surface of the first button.

A position corresponding to one pressure sensor on the first button may include a position at which the pressure sensor detects a corresponding pressure value when the position is pressed. A position corresponding to one resistive pressure sensor on the first button may include a position at which the resistive pressure sensor generates corresponding deformation when the position is pressed. For example, the position corresponding to the pressure sensor 1 on the first button is located in the area 1. When a press operation is performed on the area 1 of the first button, the pressure sensor 1 may detect pressure generated by the press operation.

The position distribution of the pressure sensor 1 to the pressure sensor 6 is merely an example for description in this application, and should not constitute a limitation on this application. Not limited to the pressure sensor 1 to the pressure sensor 6, the first button may further include more or fewer pressure sensors.

**FIG. 6A** **is an example of a method for detecting a type of a touch operation based on pressure data.**

S611: k pressure sensors in a first button sequentially detect pressure data, and the pressure data is greater than a pressure threshold.

It can be learned from the pressure sensors shown in FIG. 3C and FIG. 5 that the pressure data detected by the pressure sensors in the first button is related to a position pressed on the first button by using the touch operation. When the position pressed on the first button by using the touch operation changes, the pressure data detected by the pressure sensor in the first button also changes accordingly.

For example, when the position at which the touch operation is performed on the first button swipes from the area 1 to the area 2, the pressure sensor 1 detects, before the pressure sensor 2, pressure data greater than the pressure threshold. When the touch operation is performed on the area 1, the pressure data detected by the pressure sensor 1 gradually increases. In a process in which the touch operation is swiping from the area 1 to the area 2, the pressure data detected by the pressure sensor 1 gradually decreases, and pressure data detected by the pressure sensor 2 gradually increases.

In some embodiments, when the k pressure sensors in the first button sequentially detect the pressure data greater than the pressure threshold, the electronic device 100 may determine that the touch operation performed on the first button is a swipe operation. Here, k is an integer greater than 1.

That pressure data detected by a pressure sensor in the first button is greater than the pressure threshold may indicate that there is a high probability that a touch operation is performed on the first button. This can reduce cases in which a mistouch on the first button is identified as a touch operation of a user.

The pressure threshold in step S611 may be the same as or different from the pressure threshold in step S411 shown in FIG. 4. This is not limited in embodiments of this application. The pressure threshold in step S611 may be a second pressure threshold.

S612: Determine, based on position distribution of the k pressure sensors and moments at which the k pressure sensors detect the pressure data greater than the pressure threshold, a swipe direction of the touch operation performed on the first button.

Based on the position distribution of the k pressure sensors and the moments at which the k pressure sensors detect the pressure data greater than the pressure threshold, the electronic device 100 may determine positions that are on the first button and on which the swipe operation of the user is sequentially performed, and further determine the swipe direction of the swipe operation.

The swipe direction may include but is not limited to: swiping to the left, swiping to the right, swiping upward, swiping downward, swiping diagonally down to the left, swiping diagonally up to the left, swiping diagonally down to the right, swiping diagonally up to the right, and the like. Swipe operations in different swipe directions may be used to trigger the electronic device 100 to execute different tasks. For example, a swipe operation of swiping to the left on the first button may be used to implement a task of controlling remote image shooting of a mobile phone. A swipe operation of swiping upward on the first button may be used to implement a task of controlling music playing. Tasks corresponding to the swipe operations in the different swipe directions are not limited in embodiments of this application.

For example, the k pressure sensors are the pressure sensor 1, the pressure sensor 3, and the pressure sensor 5 shown in FIG. 5. A moment at which the pressure sensor 1 detects pressure data greater than the pressure threshold is t1. A moment at which the pressure sensor 3 detects pressure data greater than the pressure threshold is t2. A moment at which the pressure sensor 5 detects pressure data greater than the pressure threshold is t3. Here, t1 is earlier than t2, and t2 is earlier than t3. In addition, a time difference between t1 and t2 and a time difference between t2 and t3 are both less than a preset time difference threshold. Based on position distribution of the pressure sensor 1, the pressure sensor 3, and the pressure sensor 5, t1, t2, and t3, the electronic device 100 may determine that the swipe direction of the touch operation performed on the first button is swiping downward. That is, the touch operation performed on the first button is a swipe-down operation.

For another example, the k pressure sensors are the pressure sensor 1, the pressure sensor 3, and the pressure sensor 5 shown in FIG. 5. A moment at which the pressure sensor 1 detects pressure data greater than the pressure threshold is t4. A moment at which the pressure sensor 3 detects pressure data greater than the pressure threshold is t5. A moment at which the pressure sensor 5 detects pressure data greater than the pressure threshold is t6. Here, t4 is later than t5, and t5 is later than t6. In addition, a time difference between t4 and t5 and a time difference between t5 and t6 are both less than a preset time difference threshold. Based on position distribution of the pressure sensor 1, the pressure sensor 3, and the pressure sensor 5, t4, t5, and t6, the electronic device 100 may determine that the swipe direction of the touch operation performed on the first button is swiping upward. That is, the touch operation performed on the first button is a swipe-up operation.

It can be learned from the foregoing method that, when a plurality of pressure sensors are disposed in the first button, the electronic device 100 may detect a swipe direction of a touch operation performed on the first button, and further execute a corresponding task based on the swipe direction.

In some embodiments, the electronic device 100 may identify, by using the plurality of pressure sensors in the first button, whether the touch operation performed on the first button is a press operation or a swipe operation. If the touch operation is a press operation, there is usually only one position at which the touch operation is performed on the first button. For example, the press operation is performed on the area 1 or the area 3 shown in FIG. 5. If the touch operation is a swipe operation, a position at which the touch operation is performed on the first button is changeable, and there are a plurality of positions at which the touch operation is performed on the first button. For example, the swipe operation is sequentially performed on the area 1, the area 3, and the area 5 shown in FIG. 5. Therefore, a change trend of pressure data of a plurality of pressure sensors when a press operation is performed on the first button is different from a change trend of pressure data of a plurality of pressure sensors when a swipe operation is performed on the first button.

When a change trend that pressure data of a plurality of pressure sensors in the first button simultaneously increases and then simultaneously decreases is detected, the electronic device 100 may determine that the touch operation on the first button is the press operation. Optionally, the plurality of pressure sensors may be pressure sensors that are adjacent in the first button.

When a change trend that pressure data of one pressure sensor in the first button decreases, and pressure data of another pressure sensor increases is detected, the electronic device 100 may determine that the touch operation on the first button is the swipe operation. Optionally, the pressure sensor and the another pressure sensor may be pressure sensors that are adjacent in the first button. In other words, that pressure data of a plurality of pressure sensors in the first button changes in opposite trends in a time period may indicate that a swipe operation is performed on the first button.

It may be understood that, when a press operation is performed on the first button, a plurality of pressure sensors in the first button are simultaneously pressed and then simultaneously released. Therefore, pressure data of the plurality of pressure sensors simultaneously changes in a same trend. When a swipe operation is performed on the first button, a plurality of pressure sensors in the first button are pressed in sequence. When the swipe operation is swiping from an area corresponding to one pressure sensor to an area corresponding to another pressure sensor, pressure data of the pressure sensor decreases, and pressure data of the other pressure sensor increases. Therefore, pressure data of the plurality of pressure sensors changes in opposite trends in a same time period.

When it is determined that the touch operation on the first button is a press operation, the electronic device 100 may execute a task corresponding to the press operation. When it is determined that the touch operation on the first button is a swipe operation, the electronic device 100 may execute a task corresponding to the swipe operation. The task corresponding to the press operation may be different from the task corresponding to the swipe operation. Optionally, when the touch operation is a swipe operation, the electronic device 100 may identify a type of the swipe operation, namely, a swipe direction. For example, the electronic device 100 identifies a swipe direction of the swipe operation based on the pressure data (refer to the method shown in FIG. 6A). When the touch operation is a press operation, the electronic device 100 may identify a type of the press operation (for example, a touch and hold operation, a tap operation, a light tap operation, or a heavy tap operation). Swipe operations in different swipe directions may correspond to different tasks. Different types of press operations may also correspond to different tasks.

It can be learned that, the electronic device 100 may identify, by using one or more sensors in the first button, a plurality of types of touch operations performed on the first button. In this way, the first button supports various user interaction modes. The user may perform a plurality of touch operations on the first button to use corresponding functions. The one or more sensors disposed in the first button may not be affected by a water medium. When the user carries the electronic device 100 underwater, the user may still control the electronic device 100 underwater through the first button.

In some embodiments, the electronic device 100 may determine, based on the pressure data detected by the pressure sensor in the first button, pressing duration of the touch operation performed on the first button. The electronic device 100 may determine the type of the touch operation based on the pressing duration. The type of the touch operation may include press operations with different pressing duration, for example, a tap operation and a touch and hold operation. In this application, an example in which the touch operation is classified into a tap operation and a touch and hold operation based on the pressing duration is specifically used for description.

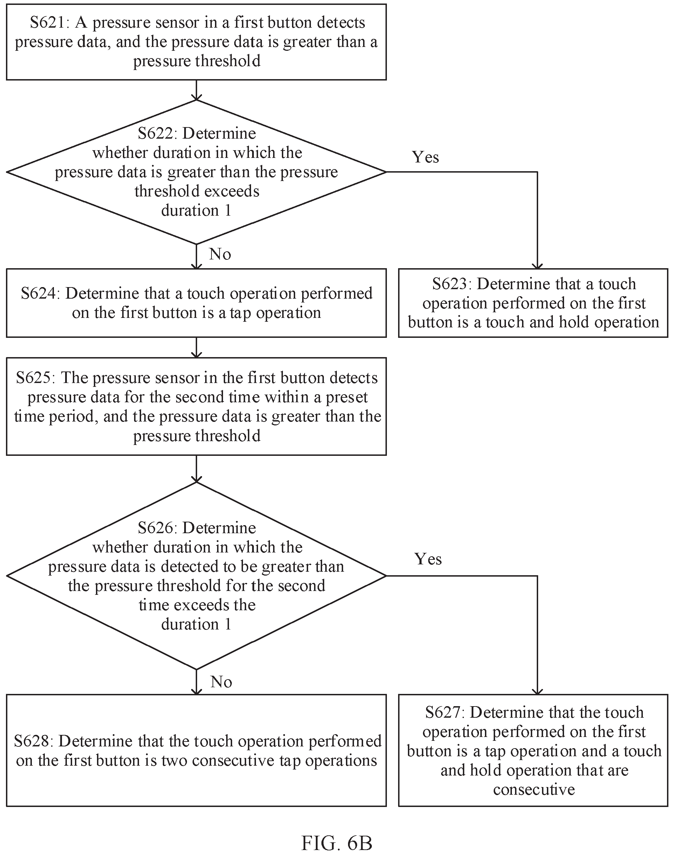

**FIG. 6B** **is an example of another method for detecting a type of a touch operation based on pressure data.**

S621: A pressure sensor in a first button detects pressure data, and the pressure data is greater than a pressure threshold.

It can be learned from the foregoing embodiments that the pressure data being greater than the pressure threshold may indicate that there is a high probability that a touch operation is performed on the first button. This can reduce cases in which a mistouch on the first button is identified as a touch operation of a user.

S622: Determine whether duration in which the pressure data is greater than the pressure threshold exceeds duration 1.

The electronic device 100 may determine pressing duration of the touch operation based on the pressure data of the pressure sensor in the first button. The pressing duration of the touch operation is the duration in which the pressure data is greater than the pressure threshold.

If the duration in which the pressure data is greater than the pressure threshold exceeds the duration 1, the electronic device 100 may perform the following step S623. In other words, a touch and hold operation is performed on the first button.

If the duration in which the pressure data is greater than the pressure threshold does not exceed the duration 1, the electronic device 100 may perform the following step S624. In other words, a tap operation is performed on the first button.

The duration 1 may be preset. A value of the duration 1 is not limited in this application.

S623: Determine that the touch operation performed on the first button is a touch and hold operation.

S624: Determine that the touch operation performed on the first button is a tap operation.

S625: The pressure sensor in the first button detects pressure data for the second time within a preset time period, and the pressure data is greater than the pressure threshold.

In some embodiments, the touch operation performed on the first button may be two consecutive press operations. That the pressure sensor in the first button detects, two consecutive times within the preset time period, pressure data greater than the pressure threshold may indicate that the touch operation is two consecutive press operations. Detecting, two consecutive times, the pressure data greater than the pressure threshold may include: The pressure data detected by the pressure sensor in the first button first increases to be greater than the pressure threshold, then decreases to be less than the pressure threshold, and then increases again to be greater than the pressure threshold.

A value of the preset time period is not limited in this application. For example, the preset time period may be 500 ms, 1s, or the like.

S626: Determine whether duration in which the pressure data is detected to be greater than the pressure threshold for the second time exceeds the duration 1.

The electronic device 100 may determine, based on the pressure data of the pressure sensor in the first button, duration in which the pressure data is detected to be greater than the pressure threshold for the first time and the duration in which the pressure data is detected to be greater than the pressure threshold for the second time. The electronic device 100 may determine whether the duration in which the pressure data is detected to be greater than the pressure threshold for the first time exceeds the duration 1 (refer to the foregoing step S622), and determine whether the duration in which the pressure data is detected to be greater than the pressure threshold for the second time exceeds the duration 1.

If the duration in which the pressure data is detected to be greater than the pressure threshold for the second time exceeds the duration 1, it may indicate that a second press in the touch operation is a touch and hold. If the duration in which the pressure data is detected to be greater than the pressure threshold for the second time does not exceed the duration 1, it may indicate that the second press in the touch operation is a tap.

When a first press in the touch operation is a tap (namely, the foregoing step S624), and the second press is a touch and hold, the electronic device 100 may perform the following step S627. In other words, a tap operation and a touch and hold operation that are consecutive are performed on the first button.

When the first press in the touch operation is a tap, and the second press is a tap, the electronic device 100 may perform the following step S628. In other words, two consecutive tap operations (for example, an operation of double-tapping the first button) are performed on the first button.

S627: Determine that the touch operation performed on the first button is a tap operation and a touch and hold operation that are consecutive.

S628: Determine that the touch operation performed on the first button is two consecutive tap operations.

In some embodiments, the electronic device 100 may determine whether the touch operation performed on the first button is a press operation. When the touch operation is the press operation, the electronic device 100 may determine the pressing duration of the touch operation according to the method shown in FIG. 6B, to determine whether the touch operation is a tap operation or a touch and hold operation.

In some embodiments, the electronic device 100 may determine, based on the pressure data detected by the pressure sensor in the first button, a press force of the touch operation performed on the first button. The electronic device 100 may determine a type of the touch operation based on the press force. The type of the touch operation may include press operations with different press forces, for example, a light tap operation and a heavy tap operation. In this application, an example in which the touch operation is classified into a light tap operation and a heavy tap operation based on the press force is specifically used for description.

**FIG. 6C** **is an example of another method for detecting a type of a touch operation** based on pressure data.

S631: A pressure sensor in a first button detects the pressure data.

S632: Determine, based on a value of the pressure data, whether the touch operation performed on the first button is a light tap operation or a heavy tap operation.

The electronic device 100 may determine, based on the value of the pressure data, whether the pressure data belongs to a first pressure range or a second pressure range. The first pressure range is less than the second pressure range. The first pressure range is greater than a preset pressure threshold. This can reduce cases in which a mistouch on the first button is identified as a touch operation of a user. Sizes and scopes of the first pressure range and the second pressure range are not limited in embodiments of this application.

If the pressure data belongs to the first pressure range, the electronic device 100 may determine that the touch operation performed on the first button is the light tap operation.

If the pressure data belongs to the second pressure range, the electronic device 100 may determine that the touch operation performed on the first button is the heavy tap operation.

Not limited to the first pressure range and the second pressure range, the electronic device 100 may further obtain more pressure ranges through division, to distinguish between press operations at different levels based on a press force.

It can be learned from the methods shown in FIG. 6A to FIG. 6C that the electronic device 100 may identify, by using the pressure sensor in the first button, a plurality of types of touch operations performed on the first button. In this way, the first button supports various user interaction modes. The user may perform a plurality of touch operations on the first button to use corresponding functions. The one or more sensors disposed in the first button may not be affected by a water medium. When the user carries the electronic device 100 underwater, the user may still control the electronic device 100 underwater through the first button.

In some embodiments, the electronic device 100 may detect, based on an optical sensor disposed in a button, a type of a touch operation performed on the button.

**FIG. 7** **is an example of a diagram of position distribution of an optical transmitter and optical receivers that are included in an optical sensor of a first button.**

The optical sensor may be disposed in the first button. As shown in FIG. 7, the optical sensor may include an optical transmitter, an optical receiver 1, an optical receiver 2, an optical receiver 3, and an optical receiver 4. The optical receiver 1 and the optical receiver 2 may be distributed on one side of the optical transmitter. The optical receiver 3 and the optical receiver 4 may be distributed on another layer of the optical transmitter. In some embodiments, a distance between centers of an optical receiver and the optical transmitter that are included in the optical sensor may not exceed 15 millimeters. A distance between the optical receiver and the optical transmitter is not limited in embodiments of this application. The distance may depend on power of the optical transmitter. Larger power of the optical transmitter indicates that the optical receiver may be farther away from the optical transmitter. The optical sensor in the first button may include a plurality of optical transmitters. Not limited to the optical receiver 1 to the optical receiver 4 shown in FIG. 7, the optical sensor in the first button may include more or fewer optical receivers.

In some embodiments, the optical transmitter may transmit light whose wavelength is greater than or equal to 940 nanometers (nm). The light whose wavelength is greater than or equal to 940 nm is light invisible to naked eyes of a user. In this way, an optical signal transmitted by the optical transmitter can be prevented from affecting user experience. The wavelength of the light transmitted by the optical transmitter is not limited in embodiments of this application.

The position distribution of the optical transmitter and the optical receivers shown in FIG. 7 is merely an example for description in this application, and should not constitute a limitation on this application.

**FIG. 8A** **is an example of a method for detecting a type of a touch operation based on a photoelectric current signal.**

S811: m optical receivers in a first button sequentially detect photoelectric current signals whose signal strength is greater than a signal strength threshold.

It can be learned from the optical sensor shown in FIG. 3D and FIG. 7 that, an amount of optical signals received by the optical receiver in the first button is related to a position pressed on the first button by using the touch operation. When the position pressed on the first button by using the touch operation changes, the amount of optical signals received by the optical receiver changes accordingly. Because the amount of optical signals changes, the strength of the photoelectric current signal also changes.

A photoelectric current signal detected by one optical receiver may be a photoelectric current signal determined based on an optical signal received by the optical receiver. More optical signals received by one optical receiver indicate a stronger signal strength of a photoelectric current signal detected by the optical receiver.

For example, when the position at which the touch operation is performed on the first button is swiped from a position corresponding to an optical receiver 1 to a position corresponding to an optical receiver 2, the optical receiver 1 receives, before the optical receiver 2, an optical signal absorbed, reflected, and scattered by a human tissue. The optical receiver 1 detects, before the optical receiver 2, a photoelectric current signal whose signal strength is greater than the signal strength threshold. When the touch operation is pressing on a position corresponding to the optical receiver 1 on the first button, the signal strength of the photoelectric current signal detected by the optical receiver 1 gradually increases. In a process in which the touch operation is swiped from the position corresponding to the optical receiver 1 on the first button to the position corresponding to the optical receiver 2 on the first button, the signal strength of the photoelectric current signal detected by the optical receiver 1 gradually decreases, and a signal strength of a photoelectric current signal detected by the optical receiver 2 gradually increases.

In some embodiments, when the m optical receivers in the first button sequentially detect photoelectric current signals whose signal strength is greater than the signal strength threshold, the electronic device 100 may determine that the touch operation performed on the first button is a swipe operation. Here, m is an integer greater than 1.

That a signal strength of a photoelectric current signal detected by an optical receiver in the first button is large may indicate that there is a high probability that a touch operation is performed on the first button. This can reduce cases in which a mistouch on the first button is identified as a touch operation of a user.

The signal strength threshold in step S811 may be the same as or different from the signal strength threshold in step S413 shown in FIG. 4. This is not limited in embodiments of this application. The signal strength threshold in step S811 may be a second signal strength threshold.

S812: Determine, based on position distribution of the m optical receivers and moments at which the m optical receivers detect the photoelectric current signal whose signal strength is greater than the signal strength threshold, a swipe direction of the touch operation performed on the first button.

Based on the position distribution of the m optical receivers and the moments at which the m optical receivers detect the photoelectric current signal whose signal strength is greater than the signal strength threshold, the electronic device 100 may determine positions that are on the first button and on which the swipe operation is sequentially performed, and further determine a swipe direction of the swipe operation.

For example, the m optical receivers may be the optical receiver 1 and the optical receiver 3 shown in FIG. 7. A moment at which the optical receiver 1 detects a photoelectric current signal whose signal strength is greater than the signal strength threshold is t7. A moment at which the optical receiver 3 detects a photoelectric current signal whose signal strength is greater than the signal strength threshold is t8. Here, t7 is earlier than t8, and a time difference between t7 and t8 is less than a preset time difference threshold. Based on the position distribution of the optical receiver 1 and the optical receiver 3, t7, and t8, the electronic device 100 may determine that the swipe direction of the touch operation performed on the first button is swiping downward. That is, the touch operation performed on the first button is a swipe-down operation.

It can be learned from the foregoing method that, when a plurality of optical receivers are disposed in the first button, the electronic device 100 may detect a swipe direction of a touch operation performed on the first button, and further execute a corresponding task based on the swipe direction.

In some embodiments, the electronic device 100 may identify, by using the plurality of optical receivers in the first button, whether the touch operation performed on the first button is a press operation or a swipe operation. A change trend of strengths of photoelectric current signals of the plurality of optical receivers when a press operation is performed on the first button is different from a change trend of strengths of photoelectric current signals of the plurality of optical receivers when a swipe operation is performed on the first button.

When a change trend that the strengths of the photoelectric current signals of the plurality of optical receivers in the first button simultaneously increases and then simultaneously decreases is detected, the electronic device 100 may determine that the touch operation on the first button is the press operation. Optionally, the plurality of optical receivers may be optical receivers that are adjacent in the first button.

When there is a change trend that when a strength of a photoelectric current signal of one optical receiver in the first button decreases, a strength of a photoelectric current signal of another optical receiver increases is detected, the electronic device 100 may determine that the touch operation on the first button is the swipe operation. Optionally, the optical receiver and the another optical receiver may be optical receivers that are adjacent in the first button. In other words, that strengths of photoelectric current signals of the plurality of optical receivers in the first button change in opposite trends in a time period may indicate that a swipe operation is performed on the first button.

It may be understood that, when a press operation is performed on the first button, a plurality of optical receivers in the first button are simultaneously pressed and then simultaneously released. Therefore, strengths of photoelectric current signals of the plurality of optical receivers change in a same trend at the same time. When a swipe operation is performed on the first button, a plurality of optical receivers in the first button are pressed in sequence. When the swipe operation is swiping from a position corresponding to one optical receiver on the first button to a position corresponding to another optical receiver on the first button, a strength of a photoelectric current signal of the optical receiver decreases, and a strength of a photoelectric current signal of the another optical receiver increases. Therefore, strengths of photoelectric current signals of the plurality of optical receivers change in opposite trends in a same time period.

It can be learned that the electronic device 100 may identify, by using the optical sensor in the first button, the press operation and the swipe operation that are performed on the first button, and further execute a task corresponding to a corresponding touch operation. According to the foregoing embodiments, user interaction experience of the electronic device 100 can be improved.

In some embodiments, the electronic device 100 may determine, based on a photoelectric current signal detected by the optical sensor in the first button, pressing duration of the touch operation performed on the first button. The photoelectric current signal detected by the optical sensor may include a photoelectric current signal detected by one or more optical receivers included in the optical sensor. The electronic device 100 may determine a type of the touch operation based on the pressing duration. The type of the touch operation may include press operations with different pressing duration, for example, a tap operation and a touch and hold operation. In this application, an example in which the touch operation is classified into a tap operation and a touch and hold operation based on the pressing duration is specifically used for description.

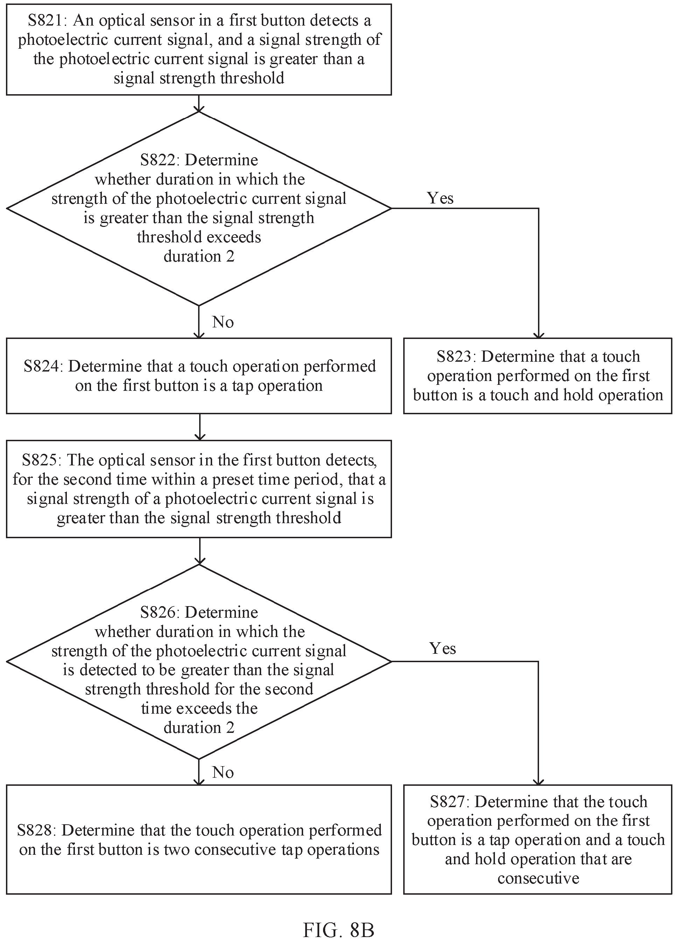

**FIG. 8B** **is an example of another method for detecting a type of a touch operation based on a photoelectric current signal.**

S821: An optical sensor in a first button detects a photoelectric current signal, and a signal strength of the photoelectric current signal is greater than a signal strength threshold.

It can be learned from the foregoing embodiments that the signal strength of the photoelectric current signal being greater than the signal strength threshold may indicate that there is a high probability that a touch operation is performed on the first button. This can reduce cases in which a mistouch on the first button is identified as a touch operation of a user.

S822: Determine whether duration in which the strength of the photoelectric current signal is greater than the signal strength threshold exceeds duration 2.

The electronic device 100 may determine pressing duration of the touch operation based on the photoelectric current signal of the optical sensor in the first button. The pressing duration of the touch operation is the duration in which the signal strength of the photoelectric current signal is greater than the signal strength threshold.

If the duration in which the strength of the photoelectric current signal is greater than the signal strength threshold exceeds the duration 2, the electronic device 100 may perform the following step S823. In other words, a touch and hold operation is performed on the first button.

If the duration in which the strength of the photoelectric current signal is greater than the signal strength threshold does not exceed the duration 2, the electronic device 100 may perform the following step S824. In other words, a tap operation is performed on the first button.

The duration 2 may be preset. A value of the duration 2 is not limited in this application.

S823: Determine that the touch operation performed on the first button is a touch and hold operation.

S824: Determine that the touch operation performed on the first button is a tap operation.

S825: The optical sensor in the first button detects, for the second time within a preset time period, that a signal strength of a photoelectric current signal is greater than the signal strength threshold.

In some embodiments, the touch operation performed on the first button may be two consecutive press operations. That the optical sensor in the first button detects, two consecutive times within the preset time period, a photoelectric current signal whose signal strength is greater than the signal strength may indicate that the touch operation is two consecutive press operations. Detecting, two consecutive times, the photoelectric current signal whose signal strength is greater than the signal strength threshold may include: The strength of the photoelectric current signal detected by the optical sensor in the first button first increases to be greater than the signal strength threshold, then decreases to be less than the signal strength threshold, and then increases again to be greater than the signal strength threshold.

A value of the preset time period is not limited in this application. For example, the preset time period may be 500 ms, 1s, or the like.

S826: Determine whether duration in which the strength of the photoelectric current signal is detected to be greater than the signal strength threshold for the second time exceeds the duration 2.

The electronic device 100 may determine, based on the photoelectric current signal of the optical sensor in the first button, duration in which the photoelectric current signal whose signal strength is greater than the signal strength threshold is detected for the first time and the duration in which the photoelectric current signal whose signal strength is greater than the signal strength threshold is detected for the second time. The electronic device 100 may determine whether the duration in which the photoelectric current signal whose signal strength is greater than the signal strength threshold is detected for the first time exceeds the duration 2 (refer to the foregoing step S822), and determine whether the duration in which the photoelectric current signal whose signal strength is greater than the signal strength threshold is detected for the second time exceeds the duration 2.

That the duration in which the photoelectric current signal whose signal strength is greater than the signal strength threshold is detected for the second time exceeds the duration 2 may indicate that a second press in the touch operation is a touch and hold. That the duration in which the photoelectric current signal whose signal strength is greater than the signal strength threshold is detected for the second time does not exceed the duration 2 may indicate that the second press in the touch operation is a tap.

When a first press in the touch operation is a tap (namely, the foregoing step S824), and the second press is a touch and hold, the electronic device 100 may perform the following step S827. In other words, a tap operation and a touch and hold operation that are consecutive are performed on the first button.

When the first press in the touch operation is a tap, and the second press is a tap, the electronic device 100 may perform the following step S828. In other words, two consecutive tap operations (for example, an operation of double-tapping the first button) are performed on the first button.

S827: Determine that the touch operation performed on the first button is a tap operation and a touch and hold operation that are consecutive.

S828: Determine that the touch operation performed on the first button is two consecutive tap operations.

In some embodiments, the electronic device 100 may determine whether the touch operation performed on the first button is a press operation. When the touch operation is the press operation, the electronic device 100 may determine the pressing duration of the touch operation according to the method shown in FIG. 8B, to determine whether the touch operation is a tap operation or a touch and hold operation.

In some embodiments, the electronic device 100 may determine, based on the photoelectric current signal detected by the optical sensor in the first button, a press force of the touch operation performed on the first button. The electronic device 100 may determine a type of the touch operation based on the press force. The type of the touch operation may include press operations with different press forces, for example, a light tap operation and a heavy tap operation.

It can be learned from the optical sensor shown in FIG. 3D that, a larger press force of the touch operation on the first button indicates a stronger strength of the photoelectric current signal. The electronic device 100 may determine whether the strength of the photoelectric current signal belongs to a first signal strength range or a second signal strength range. The first signal strength range is less than the second signal strength range. The first signal strength range is greater than a preset signal strength threshold. This can reduce cases in which a mistouch on the first button is identified as a touch operation of the user. Sizes and scopes of the first signal strength range and the second signal strength range are not limited in embodiments of this application.

If the strength of the photoelectric current signal belongs to the first signal strength range, the electronic device 100 may determine that the touch operation performed on the first button is a light tap operation.

If the strength of the photoelectric current signal belongs to the second signal strength range, the electronic device 100 may determine that the touch operation performed on the first button is a heavy tap operation.

Not limited to the first signal strength range and the second signal strength range, the electronic device 100 may further obtain more signal strength ranges through division, to distinguish between press operations at different levels based on a press force.

In some embodiments, because a larger press force of the touch operation on the first button indicates a sharper waveform of the photoelectric current signal, the electronic device 100 may determine the press force of the touch operation based on the waveform of the photoelectric current signal. The electronic device 100 may determine a sharpness degree of the waveform of the photoelectric current signal. A larger waveform sharpness degree may indicate a sharper waveform of the photoelectric current signal. If the sharpness degree of the waveform of the photoelectric current signal exceeds a preset sharpness degree threshold, the electronic device 100 may determine that a heavy tap operation is performed on the first button. If the sharpness degree of the waveform of the photoelectric current signal does not exceed the preset sharpness degree threshold, the electronic device 100 may determine that a light operation is performed on the first button.

It can be learned from the methods shown in FIG. 8A and FIG. 8B that the electronic device 100 may identify, by using the optical sensor in the first button, a plurality of types of touch operations performed on the first button. In this way, the first button supports various user interaction modes. The user may perform a plurality of touch operations on the first button to use corresponding functions.

In some embodiments, the electronic device 100 may detect, based on a bioelectric sensor disposed in a button, a type of a touch operation performed on the button.

It can be learned from step S412 shown in FIG. 4 that, when a touch operation is performed on the first button, the bioelectric sensor in the first button may detect a bioelectric signal, and the bioelectric sensor in the first button is connected to another bioelectric sensor disposed outside the first button. When it is determined that a touch operation is performed on the first button, the electronic device 100 may determine, based on the bioelectric signal detected by the bioelectric sensor in the first button, pressing duration of the touch operation performed on the first button. The electronic device 100 may determine a type of the touch operation based on the pressing duration. The type of the touch operation may include press operations with different pressing duration, for example, a tap operation and a touch and hold operation.

The pressing duration of the touch operation may be duration in which the bioelectric sensor in the first button is connected to the another bioelectric sensor disposed outside the first button, namely, duration in which the bioelectric sensor in the first button detects the bioelectric signal. The electronic device 100 may determine whether the pressing duration of the touch operation exceeds duration 3. If the pressing duration of the touch operation exceeds the duration 3, the electronic device 100 may determine that the touch operation is a touch and hold operation. If the pressing duration of the touch operation does not exceed the duration 3, the electronic device 100 may determine that the touch operation is a tap operation.

A value of the duration 3 is not limited in embodiments of this application.

Optionally, the electronic device 100 may detect whether the bioelectric sensor in the first button is connected to the another bioelectric sensor disposed outside the first button twice within a preset time period. The foregoing two times of connection may indicate that the touch operation performed on the first button is two consecutive press operations. The electronic device 100 may detect duration of the two times of connection. In the foregoing two times of connection, if duration of the first time of connection does not exceed the duration 3, and duration of the second time of connection exceeds the duration 3, the electronic device 100 may determine that a tap operation and a touch and hold operation that are consecutive are performed on the first button. If the duration of each of the two times of connection does not exceed the duration 3, the electronic device 100 may determine that two consecutive tap operations (for example, an operation of double-tapping the first button) are performed on the first button.

In some embodiments, a plurality of bioelectric sensors (for example, a plurality of ECG electrodes) may be disposed in the first button. The electronic device 100 may determine, based on moments at which the plurality of bioelectric sensors detect bioelectric signals, whether the touch operation performed on the first button is a press operation or a swipe operation. Optionally, when the touch operation performed on the first button is the swipe operation, the electronic device 100 may further determine a swipe direction of the swipe operation in combination with position distribution of the plurality of bioelectric sensors.

When the plurality of bioelectric sensors in the first button detect bioelectric signals at the same time, and then cannot detect the bioelectric signals at the same time, the electronic device 100 may determine that the touch operation on the first button is the press operation. Optionally, the plurality of bioelectric sensors may be bioelectric sensors that are adjacent in the first button.

When the plurality of bioelectric sensors in the first button sequentially detect bioelectric signals, the electronic device 100 may determine that the touch operation on the first button is the swipe operation. Based on the position distribution of the plurality of bioelectric sensors and the moments at which the plurality of bioelectric sensors detect the bioelectric signals, the electronic device 100 may determine a position of the swipe operation of the user on the first button, and further determine the swipe direction of the swipe operation.

It can be learned from the foregoing embodiments that the electronic device 100 may detect the type of the touch operation on the first button by using any one of the pressure sensor, the optical sensor, and the bioelectric sensor.

Optionally, the electronic device 100 may further detect the type of the touch operation on the first button by using a plurality of sensors in the pressure sensor, the optical sensor, and the bioelectric sensor. For example, the electronic device 100 detects the type of the touch operation on the first button by using the pressure sensor and the optical sensor in the first button. When it is determined, based on the pressure data, that a tap operation is performed on the first button, and it is determined, based on the photoelectric current signal, that the tap operation is performed on the first button, the electronic device 100 may determine that the tap operation is performed on the first button. A method for detecting, by the electronic device 100, a type of a touch operation on the first button by using a plurality of sensors in the pressure sensor, the optical sensor, and the bioelectric sensor is not limited in embodiments of this application.

In some embodiments, the first button may be used for blood pressure monitoring. When the blood pressure monitoring is performed, the user needs to touch the first button with a finger. The electronic device 100 may determine blood pressure of the user based on a PPG signal detected by the optical sensor in the first button and a bioelectric signal detected by the bioelectric sensor. Therefore, a position at which the finger of the user touches the first button needs to cover a position corresponding to the optical sensor on the first button. It can be learned from FIG. 3A that the first button is a physical button with a specific length. A position corresponding to the optical sensor on the first button may occupy only a partial area of a touch surface of the first button, for example, a lower half part area of the first button. If the finger of the user is placed in an inappropriate position on the first button when the user performs blood pressure monitoring, the blood pressure monitoring may fail or a blood pressure monitoring result may have a large error.

The electronic device 100 may detect, by using the pressure sensor in the first button, whether the finger of the user is placed in an appropriate position during the blood pressure monitoring. Optionally, when the finger of the user is placed in the appropriate position, the electronic device 100 may further detect whether signal quality of the PPG signal meets a preset quality indicator. When the signal quality of the PPG signal meets the preset quality indicator, the electronic device 100 may determine the blood pressure of the user based on the PPG signal and the bioelectric signal. In this way, accuracy of the blood pressure monitoring can be improved.

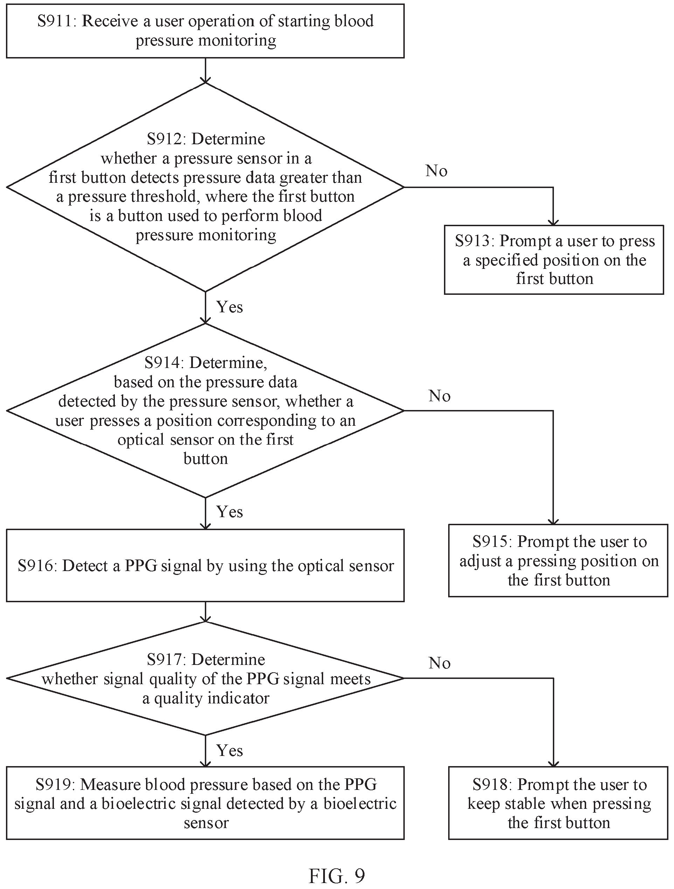

**FIG. 9** **is an example of a method for performing blood pressure monitoring through a first button.**

As shown in FIG. 9, the method may include step S911 to step S919.

S911: Receive a user operation of starting blood pressure monitoring.

The user operation of starting blood pressure monitoring may include a user operation of invoking, in the electronic device 100, an application used for blood pressure monitoring and triggering the electronic device 100 to start the blood pressure monitoring. For example, the user operation of blood pressure monitoring may be an operation performed on a screen of the electronic device 100. The user operation of starting blood pressure monitoring is not limited in embodiments of this application.

In some embodiments, in response to the user operation of starting blood pressure monitoring, the electronic device 100 may display an operation prompt for blood pressure monitoring on the screen. The operation prompt may be used to prompt the user how to use the electronic device 100 to perform blood pressure monitoring. For example, the operation prompt may include prompting the user to place a finger on the first button. Content of the operation prompt is not limited in embodiments of this application.

S912: Determine whether a pressure sensor in the first button detects pressure data greater than a pressure threshold, where the first button is a button used to perform blood pressure monitoring.

The electronic device 100 may obtain the pressure data detected by the pressure sensor in the first button, and determine whether the pressure data is greater than the pressure threshold. It may be understood that the electronic device 100 may determine, by determining whether the pressure data is greater than the pressure threshold, whether the user presses the finger on the first button. If the pressure data is less than or equal to the pressure threshold, it may indicate that the user does not press the finger on the first button. Therefore, the electronic device 100 may prompt the user to press the first button. That the pressure data is greater than the pressure threshold may indicate that the user has pressed the finger on the first button. Therefore, the electronic device 100 may detect whether a position at which the finger of the user presses the first button is appropriate.

If the pressure data is less than or equal to the pressure threshold, the electronic device 100 may perform the following step S913.

If the pressure data is greater than the pressure threshold, the electronic device 100 may perform the following step S914.

S913: Prompt the user to press a specified position on the first button.

After the blood pressure monitoring is started, if the pressure data detected by the pressure sensor in the first button is less than or equal to the pressure threshold, the electronic device 100 may prompt the user to press the specified position on the first button. The specified position may be a position corresponding to the optical sensor on the first button. For example, the specified position may be a position of the light transmission area 1 and a position of the light transmission area 2 shown in FIG. 3A.

S914: Determine, based on the pressure data detected by the pressure sensor, whether the user presses the position corresponding to the optical sensor on the first button.

In some embodiments, a plurality of pressure sensors may be disposed in the first button. The electronic device 100 may detect, based on pressure data detected by the plurality of pressure sensors, a pressing position of a touch operation on the first button (refer to the foregoing descriptions of the pressure sensor in FIG. 3C).

If the pressing position of the touch operation on the first button is not the position corresponding to the optical sensor on the first button, the electronic device 100 may perform the following step S915.

If the pressing position of the touch operation on the first button is the position corresponding to the optical sensor on the first button, the electronic device 100 may perform the following step S916.

S915: Prompt the user to adjust the pressing position on the first button.

The electronic device 100 may display prompt information for adjusting the pressing position. The prompt information may include information about the position corresponding to the optical sensor on the first button. In this way, the user can clearly understand a position at which the finger needs to be placed on the first button during the blood pressure monitoring.

S916: Detect a PPG signal by using the optical sensor.

When the pressing position of the touch operation on the first button is the position corresponding to the optical sensor on the first button, an optical signal received by an optical receiver in the optical sensor has undergone absorption, reflection, and scattering by a human tissue. The PPG signal determined by the optical sensor based on the received optical signal can reflect health data such as a heart rate and blood pressure of the user.

S917: Determine whether signal quality of the PPG signal meets a quality indicator.

In some embodiments, the electronic device 100 may obtain the PPG signal detected by the optical sensor, and determine the signal quality of the PPG signal. The signal quality may include but is not limited to a signal strength, signal noise, and the like. A method for determining the signal quality of the PPG signal is not limited in embodiments of this application.

If the signal quality of the PPG signal does not meet the quality indicator, an error occurs in a blood pressure monitoring result. A value of the quality indicator is not limited in this application.

If the signal quality of the PPG signal does not meet the quality indicator, the electronic device 100 may perform the following step S918.

If the signal quality of the PPG signal meets the quality indicator, the electronic device 100 may perform the following step S919.

S918: Prompt the user to keep stable when pressing the first button.

The position pressed by the finger of the user on the first button is appropriate, but the signal quality of the PPG signal does not meet the quality indicator, indicating that, when the first button is pressed, pressing is unstable, for example, the finger of the user may shake. The electronic device 100 may display prompt information on the screen, to prompt the user to keep stable when pressing the first button.

S919: Measure the blood pressure based on the PPG signal and a bioelectric signal detected by a bioelectric sensor.

If the pressing position of the finger of the user on the first button is appropriate, and the signal quality of the PPG signal meets the quality indicator, the electronic device 100 may measure the blood pressure based on the PPG signal and the bioelectric signal detected by the bioelectric sensor.

The foregoing step S917 and step S919 are optional. When it is determined, based on the pressure data, that the user presses the position corresponding to the optical sensor on the first button, the electronic device 100 may perform step S916 and step S919.

It can be learned from the foregoing method that the electronic device 100 may determine, by using the pressure sensor and the optical sensor in the first button, whether the user performs blood pressure monitoring according to an operation specification. The operation specification may include: pressing the position corresponding to the optical sensor on the first button, and keeping stable when pressing the first button. According to the foregoing method, accuracy of the blood pressure monitoring can be improved.

In addition, by comparing the method shown in FIG. 9 with the methods shown in FIG. 4, FIG. 6A to FIG. 6C, FIG. 8A, and FIG. 8B, it can be learned that in a scenario in which blood pressure monitoring is not performed, the electronic device 100 may identify a type of a touch operation performed on the first button, and then perform a corresponding task based on the type of the touch operation. In a scenario in which blood pressure monitoring is performed, the electronic device 100 may obtain a PPG signal and a bioelectric signal based on a touch operation performed on the first button, to determine blood pressure of the user.

**FIG. 10A to FIG. 10D** **are examples of diagrams of some blood pressure monitoring scenarios.**

As shown in FIG. 10A, the electronic device 100 may display a user interface 1010. The user interface 1010 may include a start control 1011. The start control 1011 may be used to trigger the electronic device 100 to start blood pressure monitoring. In response to a user operation performed on the start control 1011, the electronic device 100 may display a user interface 1020 shown in FIG. 10B. The user operation performed on the start control 1011 may be the user operation of starting blood pressure monitoring in step S911 shown in FIG. 9.

As shown in FIG. 10B, the user interface 1020 may include an operation prompt for blood pressure monitoring. The operation prompt may be used to prompt a user to press a first button. Content of the operation prompt is not limited in embodiments of this application. In some embodiments, the electronic device 100 may obtain pressure data of a pressure sensor in the first button. When the pressure data is less than or equal to a pressure threshold, the electronic device 100 may continuously display the user interface 1020. When the pressure data is greater than the pressure threshold, the electronic device 100 may determine, based on the pressure data, whether a position at which the user presses the first button is a position corresponding to an optical sensor on the first button.

As shown in FIG. 10C, the position at which the user presses the first button is not the position corresponding to the optical sensor on the first button. The electronic device 100 may display a user interface 1030. The user interface 1030 may include prompt information for adjusting the pressing position. For example, the position corresponding to the optical sensor on the first button is located in an area of a lower half part of the first button. The operation prompt may prompt the user to keep the lower half part of the first button in a pressed state. This can correct the position at which the user presses the first button, so that the user presses the position corresponding to the optical sensor on the first button. The prompt information in the user interface 1030 is not limited in embodiments of this application.

As shown in FIG. 10D, the user adjusts the pressing position on the first button, so that the position corresponding to the optical sensor on the first button is covered by a finger of the user. The electronic device 100 may determine blood pressure of the user based on data detected by the optical sensor and a biosensor in the first button. In a blood pressure monitoring process, the electronic device 100 may display a user interface 1040. The user interface 1040 may include prompt information indicating that the blood pressure monitoring is being performed. The prompt information may be used to prompt the user to continuously press the first button in the blood pressure monitoring process. The prompt information in the user interface 1040 is not limited in this application.

It can be learned from the scenarios in FIG. 10A to FIG. 10D that the electronic device 100 determines, by using the pressure sensor and the optical sensor in the first button, whether the user performs blood pressure monitoring according to an operation specification. In addition, when the user does not perform a blood pressure monitoring operation in a standard manner, the electronic device 100 may help the user adjust the blood pressure monitoring operation. In this way, user experience of the blood pressure monitoring can be improved, and accuracy of the blood pressure monitoring can be improved.

In some embodiments, the electronic device 100 may detect, through the first button provided with the pressure sensor, that the user has a risk of a limb control disorder, to provide a risk prompt for the user. The limb control disorder may include but is not limited to peripheral nerve injury, Parkinson's disease, alcohol paralysis, and the like. Peripheral nerve injury may cause loss of sensation or abnormal sensation of the user. Parkinson's disease and alcohol paralysis may cause uncontrolled shaking of fingers of the user.

**FIG. 11A to FIG. 11D** **are examples of diagrams of some scenarios of limb disorder risk detection.**

As shown in FIG. 11A, the electronic device 100 may display a user interface 1110. The user interface 1110 may include a detect control 1111. The detect control 1111 may be used to trigger the electronic device 100 to start limb control disorder detection. In response to a user operation on the detect control 1111, the electronic device 100 may display a user interface 1120 shown in FIG. 11B.

As shown in FIG. 11B, the user interface 1120 may include an operation prompt 1121 and press force information 1122.

The operation prompt 1121 may be used to prompt a user with an operation method for detecting the limb control disorder. For example, content of the operation prompt 1121 may include: Press the first button, and control a press force to be 50 g within 10s. The operation method described in the operation prompt 1121 is merely an example for description in this application, and should not constitute a limitation on this application. For example, the operation method may alternatively be controlling, within a preset time period, the press force of pressing the first button to be within a preset pressure range.

The press force information 1122 may be used to present a press force of a touch operation performed on the first button in real time. In this way, it is convenient for the user to check whether the press force of the user meets a requirement.

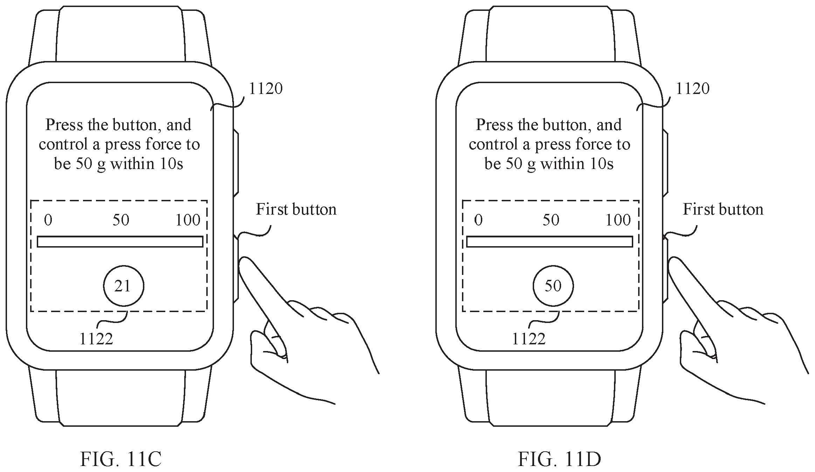

As shown in FIG. 11C, the user presses the first button. The electronic device 100 may obtain pressure data of a pressure sensor in the first button, and adjust the press force information 1122 based on the pressure data. For example, the electronic device 100 adjusts a pressure reading in the press force information 1122 to 21. This may indicate that a current press force of the user on the first button is 21 g.

As shown in FIG. 11D, the user may increase the press force on the first button. That the pressure reading in the press force information 1122 changes to 50 may indicate that the current press force of the user on the first button is 50 g.

The electronic device 100 may obtain pressure data detected by the pressure sensor in the first button within a preset time period, and determine whether the user pressing the first button meets the operation method in the operation prompt 1121. Duration of the preset time period may be duration in which the operation method in the operation prompt 1121 indicates the user to press the first button (for example, 10s).

If the user pressing the first button in the preset time period does not meet the operation method in the operation prompt 1121, the electronic device 100 may output a disease risk prompt.

For example, if the pressure data in the preset time period is less than a preset pressure value, the electronic device 100 may give the user a prompt that a risk of peripheral nerve injury exists. The preset pressure value may be a press force (for example, 50 g) that is indicated by the operation method in the operation prompt 1121 and that is used by the user to press the first button.

The electronic device 100 may calculate a fluctuation of the pressure data within the preset time period. If the fluctuation of the pressure data within the preset time period is greater than a preset fluctuation threshold, the electronic device 100 may give the user a prompt that a Parkinson's disease or alcohol paralysis risk exists. A fluctuation of pressure data in a time period may be reflected by using an indicator like a variance or a standard deviation of the pressure data. A method for calculating the fluctuation of the pressure data by the electronic device 100 is not limited in embodiments of this application.

If the user pressing the first button in the preset time period meets the operation method in the operation prompt 1121, the electronic device 100 may give the user a prompt that there is no limb control disorder. For example, if the user can control, within 10s, the press force of pressing the first button to be 50 g, it may indicate that the user is in a good health status, and a possibility of the limb control disorder is low.

Not limited to detecting peripheral nerve injury, Parkinson's disease, and alcohol paralysis, the electronic device 100 may further detect, based on the foregoing pressure data, whether the user has more other types of limb control disorders. The electronic device 100 may store a mapping table between pressure data features and limb control disorders. The mapping table may include mapping relationships between different pressure data features and different limb control disorders. For example, the pressure data feature may include that the fluctuation of the pressure data is greater than the preset fluctuation threshold. There is a mapping relationship between the pressure data feature and Parkinson's disease and alcohol paralysis. For another example, the pressure data feature may include that the pressure data is less than the preset pressure value. There is a mapping relationship between the pressure data feature and peripheral nerve injury. Content included in the pressure data feature is not limited in embodiments of this application. The electronic device 100 may search for the mapping table between pressure data features and limb control disorders, to detect a risk that the user has a limb control disorder.

It may be understood that the foregoing embodiments are merely an auxiliary judgment of whether the user has a limb control disorder. When it is determined, based on the pressure data, that the user has a limb control disorder, the electronic device 100 may provide a medical treatment suggestion for the user, to prompt the user to go to a hospital for more accurate diagnosis.

It can be learned from the scenarios shown in FIG. 11A to FIG. 11D that the electronic device 100 may simply and quickly detect, by using the pressure sensor in the first button, whether the user has a limb control disorder. When determining that the user has a limb control disorder, the electronic device 100 may output a disease risk prompt. The foregoing embodiments can help the user conveniently perform limb control disorder detection anytime and anywhere, to help the user better pay attention to physical health.

It may be understood that each user interface described in embodiments of this application is merely an example interface, and constitutes no limitation on the solutions of this application. In another embodiment, the user interface may use different interface layouts, may include more or fewer controls, and may add or reduce other function options, and provided that the user interface is based on a same inventive idea provided in this application, all fall within the protection scope of this application.

It should be noted that, if no contradiction or conflict occurs, any feature or any part of any feature in any embodiment of this application may be combined, and a combined technical solution also falls within the scope of embodiments of this application.

In conclusion, the foregoing embodiments are merely intended for describing the technical solutions of this application, but not for limiting this application. Although this application is described in detail with reference to the foregoing embodiments, persons of ordinary skill in the art should understand that they may still make modifications to the technical solutions described in the foregoing embodiments or make equivalent replacements to some technical features thereof, without departing from the scope of the technical solutions of embodiments of this application.

## Claims

1. A button operation method, wherein the method is applied to an electronic device comprising a first button, and the method comprises:
obtaining a plurality of pieces of data of a plurality of sensors, wherein the plurality of sensors are disposed in the first button, and the plurality of sensors comprise at least two of a pressure sensor, a bioelectric sensor, an optical sensor, and a temperature sensor; and
determining, based on the plurality of pieces of data, a first touch operation performed on the first button.

2. The method according to claim 1, wherein determining, based on the plurality of pieces of data, the first touch operation performed on the first button specifically comprises:
if the plurality of pieces of data meet at least two of the following conditions, determining that the first touch operation is performed on the first button:
the plurality of sensors comprise the pressure sensor, and pressure data of the pressure sensor is greater than a first pressure threshold;
the plurality of sensors comprise the optical sensor, and a signal strength of a photoelectric current signal of the optical sensor is greater than a first signal strength threshold;
the plurality of sensors comprise the bioelectric sensor, and a bioelectric signal of the bioelectric sensor indicates that the bioelectric sensor is connected to another bioelectric sensor disposed on the electronic device; and
the plurality of sensors comprise the temperature sensor, and a variation of temperature data of the temperature sensor is greater than a temperature variation threshold.

3. The method according to claim 2, wherein the plurality of sensors comprise the optical sensor, and after determining that the first touch operation is performed on the first button, the method further comprises:
determining, based on the photoelectric current signal, that a type of the first touch operation is a press operation or a swipe operation.

4. The method according to claim 3, wherein the optical sensor comprises a plurality of optical receivers, and the method further comprises:
determining a swipe direction of the first touch operation based on positions of the plurality of optical receivers and moments at which the plurality of optical receivers detect photoelectric current signals whose signal strength is greater than a second signal strength threshold.

5. The method according to claim 3, wherein the method further comprises:
determining pressing duration of the first touch operation based on the photoelectric current signal; or
determining a press force of the first touch operation based on the photoelectric current signal.

6. The method according to claim 2, wherein the plurality of sensors comprise the pressure sensor, and after determining that the first touch operation is performed on the first button, the method further comprises:
determining, based on the pressure data, that a type of the first touch operation is a press operation or a swipe operation.

7. The method according to claim 6, wherein the pressure sensor comprises a plurality of pressure sensors, and the method further comprises:
determining a swipe direction of the first touch operation based on positions of the plurality of pressure sensors and moments at which the plurality of pressure sensors detect pressure data greater than a second pressure threshold.

8. The method according to claim 6, wherein the method further comprises:
determining pressing duration of the first touch operation based on the pressure data; or
determining a press force of the first touch operation based on the pressure data.

9. The method according to any one of claims 1 to 8, wherein the plurality of sensors comprise the optical sensor and the pressure sensor, and the method further comprises:
receiving a first blood pressure monitoring operation, wherein the first blood pressure monitoring operation is used to start blood pressure monitoring;
detecting, by using the pressure sensor, a first position at which the first button is pressed through a second touch operation; and
if the first position is not in a position corresponding to the optical sensor, outputting a first prompt, wherein the first prompt is used to prompt a user to adjust a position of pressing the first button.

10. The method according to claim 9, wherein the plurality of sensors further comprise the bioelectric sensor, and the method further comprises:
if the first position is in the position corresponding to the optical sensor, determining whether signal quality of a PPG signal detected by the optical sensor meets a first quality indicator; and
if the signal quality of the PPG signal meets the first quality indicator, determining blood pressure of the user based on the PPG signal and the bioelectric signal of the bioelectric sensor; or
if the signal quality of the PPG signal does not meet the first quality indicator, outputting a second prompt, wherein the second prompt is used to prompt the user to keep stable when pressing the first button.

11. The method according to any one of claims 1 to 10, wherein the plurality of sensors comprise the pressure sensor, and the method further comprises:
displaying a first interface, wherein the first interface is used to prompt the user to press the first button, and control a press force to be a first force within first duration;
determining a press force and pressing duration of a third touch operation in response to detecting the third touch operation performed on the first button; and
outputting a disease risk prompt based on the press force and the pressing duration.

12. The method according to any one of claims 1 to 11, wherein the first button does not comprise a touch sensor.

13. A button operation method, wherein the method is applied to an electronic device comprising a first button and an optical sensor, the optical sensor is disposed in the first button, and the method comprises:
obtaining a photoelectric current signal of the optical sensor; and
determining, based on the photoelectric current signal, a first touch operation performed on the first button.

14. The method according to claim 13, wherein determining, based on the photoelectric current signal, the first touch operation performed on the first button specifically comprises:
if a signal strength of the photoelectric current signal is greater than a first signal strength threshold, determining that the first touch operation is performed on the first button.

15. The method according to claim 14, wherein after determining that the first touch operation is performed on the first button, the method further comprises:
determining, based on the photoelectric current signal, that a type of the first touch operation is a press operation or a swipe operation.

16. The method according to claim 15, wherein the optical sensor comprises a plurality of optical receivers, and the method further comprises:
determining a swipe direction of the first touch operation based on positions of the plurality of optical receivers and moments at which the plurality of optical receivers detect photoelectric current signals whose signal strength is greater than a second signal strength threshold.

17. The method according to claim 15, wherein the method further comprises:
determining pressing duration of the first touch operation based on the photoelectric current signal; or
determining a press force of the first touch operation based on the photoelectric current signal.

18. A button operation method, wherein the method is applied to an electronic device comprising a first button, an optical sensor, and a pressure sensor, the optical sensor and the pressure sensor are disposed in the first button, and the method comprises:
receiving a first blood pressure monitoring operation, wherein the first blood pressure monitoring operation is used to start blood pressure monitoring;
detecting, by using the pressure sensor, a first position at which the first button is pressed through a first touch operation; and
if the first position is not in a position corresponding to the optical sensor, outputting a first prompt, wherein the first prompt is used to prompt a user to adjust a position of pressing the first button.

19. The method according to claim 18, wherein a bioelectric sensor is further disposed in the first button, and the method further comprises:
if the first position is in the position corresponding to the optical sensor, determining whether signal quality of a PPG signal detected by the optical sensor meets a first quality indicator; and
if the signal quality of the PPG signal meets the first quality indicator, determining blood pressure of the user based on the PPG signal and a bioelectric signal of the bioelectric sensor; or
if the signal quality of the PPG signal does not meet the first quality indicator, outputting a second prompt, wherein the second prompt is used to prompt the user to keep stable when pressing the first button.

20. A button operation method, wherein the method is applied to an electronic device comprising a first button and a pressure sensor, the pressure sensor is disposed in the first button, and the method comprises:
displaying a first interface, wherein the first interface is used to prompt a user to press the first button, and control a press force to be a first force within first duration;
determining a press force and pressing duration of a touch operation in response to detecting the touch operation performed on the first button; and
outputting a disease risk prompt based on the press force and the pressing duration.

21. An electronic device, wherein the electronic device comprises a first button, a memory, and a processor, at least two of a pressure sensor, a bioelectric sensor, an optical sensor, and a temperature sensor are disposed in the first button, the memory is configured to store a computer program, and the processor is configured to invoke the computer program, so that the electronic device performs the method according to any one of claims 1 to 12, claims 13 to 17, claims 18 and 19, or claim 20.

22. A button, wherein one or more of the following sensors are disposed in the button: a pressure sensor, an optical sensor, a bioelectric sensor, and a temperature sensor; the pressure sensor is configured to detect pressure data, the optical sensor is configured to detect a photoelectric current signal, the bioelectric sensor is configured to detect a bioelectric signal, and the temperature sensor is configured to detect temperature data.

23. A computer-readable storage medium storing instructions, wherein when the instructions are run on an electronic device, the electronic device is enabled to perform the method according to any one of claims 1 to 12, claims 13 to 17, claims 18 and 19, or claim 20.

24. A computer program product, wherein the computer program product comprises computer instructions, and when the computer instructions are run on an electronic device, the electronic device is enabled to perform the method according to any one of claims 1 to 12, claims 13 to 17, claims 18 and 19, or claim 20.
